# EUROPÄISCHE PATENTSCHRIFT

(11) **EP 0 658 300 B1**
(45) Veröffentlichungstag und Bekanntmachung des Hinweises auf die Patenterteilung: **27.09.2000**
(21) Anmeldenummer: 94918266.1
(22) Anmeldetag: 24.06.1994
(51) Int. Cl.: H05K 3/00, H05K 3/28, H05K 3/42

(54) **STRUKTURIERTE LEITERPLATTEN UND FOLIENLEITERPLATTEN UND VERFAHREN ZU DEREN HERSTELLUNG**
STRUCTURED PRINTED CIRCUIT BOARDS AND FILMS AND PROCESS FOR PRODUCING THEM
CARTES DE CIRCUITS ET CARTES DE CIRCUITS SUR BANDE STRUCTUREES ET LEUR PROCEDE DE PRODUCTION

(30) Priorität: 07.07.1993 CH 203593; 07.07.1993 CH 203693
(43) Veröffentlichungstag der Anmeldung: 21.06.1995
(73) Patentinhaber: DYCONEX PATENTE AG, 6300 Zug (CH)
(72) Erfinder: MARTINELLI, Marco, CH-8413 Neftenbach (CH); SCHMIDT, Walter, CH-8050 Zürich (CH)
(74) Vertreter: Frei, Alexandra Sarah
(86) Internationale Anmeldenummer: CH9400134
(87) Internationale Veröffentlichungsnummer: WO9502312

(56) Entgegenhaltungen:
- EP-A- 0 275 686
- WO-A-92/15408
- US-A- 4 720 322
- PATENT ABSTRACTS OF JAPAN vol. 15, no. 479 (E-1141) 5. Dezember 1991 & JP,A,03 206 682 (SUMITOMO ELECTRIC IND LTD) 10. September 1991

## Beschreibung

Die Erfindung liegt auf dem Gebiet der Herstellung von Leiterplatten und sie betrifft Leiterplatten, Folienleiterplatten und Halbzeuge für Folienleiterplatten mit strukturierten Abdeckungen und mit plasma-geätzten Durchplattierungen und sie betrifft ein photochemisches Verfahren zur Herstellung derselben.

Bei der Herstellung dünner, mehrlagiger Folienleiterplatten aus Isolatorschichten und Leiterschichten werden bisher eine grössere Anzahl getrennter Strukturierungen mittels photochemischer Verfahren vorgenommen. Somit werden zur Strukturierung von Durchplattierungen in Isolatorschichten zuerst vorbereitete Durchplattierungen strukturiert, an deren Position dann später die Durchplattierungen plasma-geätzt und aufplattiert werden. Im Unterschied hierzu werden Strompfaden und Lötaugen photochemisch direkt in elektrisch leitenden Schichten strukturiert. Schliesslich erfolgt auch die photochemische Strukturierung von Abdeckungen in nachträglich aufgebrachten, schützenden Abdeckschichten auf Oberflächen von Folienleiterplatten.

Solche Strukturierungen laufen nach bekannten und bewährten photochemischen Verfahren ab, die in der Elektrotechnik weit verbreitet sind. Sie werden nacheinander angewendet und weisen als mehrstufige Herstellungsprozesse die folgenden prinzipielle Nachteile auf:

Je mehr Strukturierungen benötigt werden, desto teuerer wird die Herstellung. Für jede dieser Strukturierungen müssen Photomasken hergestellt und genau positioniert werden, ausserdem müssen Schichten von Photoresist auf das Vorfabrikat zur Herstellung von Folienleiterplatten aufgebracht und wieder entfernt werden.

Je mehr Strukturierungen benötigt werden, desto geringer ist die Ausbeute. Die Gesamtausbeute mehrerer sequentiell durchgeführter Herstellungsprozesse wird aus dem Produkt der Einzelausbeuten gebildet, der Ausschuss eines jeden Prozesses begrenzt die Ausbeute aller darauffolgenden Prozesse.

Je mehr Strukturierungen benötigt werden, desto grösser ist der fabrikationstechnische Mehraufwand. Die potentiellen physikalischen und elektronischen Möglichkeiten der verwendeten photochemischen Verfahren werden also durch die hohe Anzahl an durchgeführten Strukturierungen beschränkt. Im folgenden werden solche Beschränkungen aufgezählt:
Beschränkend sind die Fertigungstoleranzen. Dünne mehrlagige Folienleiterplatten mit Dicken kleiner 100 µm und Durchplattierungen vom Durchmesser kleiner 100 µm müssen bei mehreren Belichtungen gemäss verschiedener Photomasken für alle diese Strukturierungen gewisse Fertigungstoleranzen aufweisen, die rasch in die Grössenordnung der Strukturen selbst geraten.
Beschränkend sind die Dicken der Strompfade und der Durchplattierungen. Nach einer Strukturierung der vorgearbeiteten Durchplattierungen, werden diese plasma-geätzt und galvanisch, beispielsweise mit Kupfer aufplattiert. Diese so erhaltenen Durchplattierungen verschlechtern die Dimensionsstabilität der gesamten Folienleiterplatte, da galvanisch abgeschiedene Metalischichten nicht spannungsfrei sind. Auch führt die galvanische Aufplattierung zu einer Zunahme der Dicke der obersten Metallfolie der Folienleiterplatte selbst. Je dicker ein Metallschicht ist, desto schwerer ist sie chemisch zu Ätzen. Der physikalische Vorteil kleinster Dimensionen auf Folienleiterplatten wird so limitiert, der elektronische Vorteil dünner Strompfade ebenfalls.
Beschränkend sind schliesslich die photochemischen Strukturierungen von Abdeckungen auf Leiterplatten und Folienleiterplatten. Für die Erzeugung sehr feiner Strukturierungen in Abdeckschichten mit schaff umrissenen Rändern wird vorteilhafterweise photoempfindlicher Lötstopp-Lack oder photoempfindliche Lötstopp-Resistfolie aufgetragen. Der Lötstopp-Lack lässt sich über verschiedene Methoden wie Aufdrucken, Aufrollen, Aufgiessen elektrostatisches Aufsprühen, elektrophoretische Abscheidung, etc. aufbringen und vortrocknen. Die Löttstopp-Resistfolie wird mittels eines Vakuum-Laminators auflaminiert. Die Strukturen in diesen Abdeckungen werden über eine Photomaske mit einer hohen Strukturauflösung von 20 µm übertragen. Nachteilig sind die hohen Installationskosten für die notwendigen Maschinen, Öfen, etc. und nachteilig sind auch die hoher Verfahrenskosten, bedingt durch deren geringe Umweltverträglichkeit (Einsatz von Nasschemie und Abwasser-Aufbereitung, etc.). Auch ist der applizierte Lötstopp-Lack spröde und daher schwerlich für flexible Schaltungsträger wie Folienleiterplatten verwendbar, da er beim Biegen der Folienleiterplatten abplatzen kann.

Wünschenswert ist ein photochemisches Verfahren zur Herstellung von Leiterplatten, Folienleiterplatten und zur Herstellung von Halbzeugen für Folienleiterplatten mit strukturierten Abdeckungen und mit plasma-geätzten Durchplattierungen, die die oben beschriebenen Nachteile der mehrfachen Strukturierungen mindern. Ein solches Verfahren soll kostengünstig sein, es soll geringen Ausschuss aufweisen, es soll eine hohe Strukturauflösung und Dimensionsstabilität ermöglichen und es soll bezüglich der Formgebung solcher Strukturen in den Leiterschichten, in den Isolatorschichten und in den Abdeckschichten flexibel sein. Des weiteren sollen bekannte und bewährte Techniken, Materialien und dergleichen zur Anwendung kommen. Auch soll das Verfahren bezüglich der Weiterverarbeitung und bei wechselnden Dimensionen der zu bestückenden Bauelemente mit bekannten Verfahren kompatibel sein. Insbesondere soll die Anzahl der benötigten photochemischen Strukturierungen erniedrigt werden.

Solche Leiterplatten, Folienleiterplatten und Halbzeuge für Folienleiterplatten mit strukturierten Abdeckungen und mit plasma-geätzten Durchplattierungen werden gemäss der in den Patentansprüchen definierten Erfindung hergestellt.

Die Erfindung beruht darauf, dass sich plasma-geätzte Strukturen in Isolatorschichten nicht nur mit bekannten "chemischen" Masken (strukturiertes Photoresist), sondern auch mit "mechanischen" Masken (strukturierte plasma-ätzresistente Folie, vorzugsweise aus Leitermaterial) simultan und mit einer hohe Auflösung von kleiner 100 µm einbringen lassen. Man spricht daher auch von "mechanischen Strukturierungen" von Isolatorschichten und Abdeckschichten.

Beim erfindungsgemässen Verfahren werden Strompfade und Lötaugen in Leiterschichten photochemisch mit Hilfe von Photoresist strukturiert. Vorgearbeitete Durchplattierungen in Isolatorschichten und Abdeckungen in Abdeckschichten hingegen werden mit Hilfe der Maskenfolien mechanisch strukturiert. Dies fährt zu einer erwünschten Erniedrigung der Anzahl notwendiger photochemischer Strukturierungen.

Vorteilhafterweise sind die Isolatorschichten und Abdeckschichten Polyimidfolien und die strukturierten Maskenfolien sind Stahl- oder Kupferfolien. Die Stahl- oder Kupferfolien lassen sich reversibel oder irreversibel an den zu ätzenden Polyimid-Folien positionieren. Das heisst, dass Maskenfolien mit Folienleiterplatten fest verbunden werden können, sodass Polyimid-Folien gemäss der Strukturen von Kupferfolien plasma-geätzt werden. Das Kupfer kann dann in den Herstellungsprozess der Leiterplatten, Folienleiterplatten und der Halbzeuge für Folienleiterplatten integriert und beispielsweise in Strompfade strukturiert werden. Das heisst, dass Maskenfolien mit Folienleiterplatten aber auch nur zum Plasma-Ätzen, beispielsweise mittels Klammern, verbunden werden können. Stahlfolien werden also nur temporär auf Folienleiterplatten gespannt und daraufhin wieder entfernt und sind so ein wiederwiederverwertbare Betriebsmittel.

Wiederlösbare Maskenfolien werden so auf Isolatorschichten aufgebracht, dass die Positionen von Durchgangsöffnungen in den Maskenfolien mit den Positionen der herzustellenden Durchplattierungen oder Abdeckungen zusammenfallen. Durch dichtes Anpressen der Maskenfolien werden Folienpakete gebildet, sodass in einem Plasma-Ätz-Verfahren Durchplattierungsöffnungen und/oder Abdeckbegrenzungen gemäss den Durchgangsöffnungen der Maskenfolien in die Isolator- und/oder Abdeckschichten geätzt werden. Die Maskenfolien können sofort danach entfernt werden und dann in weiteren Herstellungsprozessen beispielsweise durch andere Maskenfolien für andere mechanische Strukturierungen ersetzt werden, sie können dann in weiteren Herstellungsprozessen beispielsweise aber auch durch Photoresist für photochemische Strukturierungen ersetzt werden.

Anhand der nachfolgend aufgeführten Figuren 1 bis 37 wird die Erfindung näher erläutert.
- Fig.1-8: zeigen eine Variante des erfindungsgemässen Verfahrens der photochemischen Strukturierung von Strompfaden und Lötaugen auf einem Teil eines Ausgangsmaterials und der mechanischen Strukturierung von Durchplattierungen mit Maskenfolien.
- Fig.9-17: zeigen eine weitere Variante des erfindungsgemässen Verfahrens der photochemischen Strukturierung von Strompfaden und Lötaugen auf einem Teil eines Ausgangsmaterials und der mechanischen Strukturierung von Durchplattierungen mittels Maskenfolien.
- Fig.18-25: zeigen eine weitere Variante des erfindungsgemässen Verfahrens der photochemischen Strukturierung von Strompfaden und Lötaugen auf einem Teil eines Ausgangsmaterials und der mechanischen Strukturierung von Durchplattierungen mittels Maskenfolien.
- Fig.26: zeigt eine Ausführungsform lokaler Schwachstellen im Ablösebereich der Maskenfolien von den Ausgangsmaterialen.
- Fig.27: zeigt eine weitere Ausführungsform lokaler Schwachstellen im Ablösebereich der Maskenfolien von den Ausgangsmaterialen.
- Fig.28-32: zeigen eine weitere Variante des erfindungsgemässen Verfahrens mit mechanischer Strukturierung von Abdeckungen auf einem Teil einer Folienleiterplatte.
- Fig.33: zeigt in einer perspektivischen Ansicht einen Teil einer beispielhaften Ausführungsform einer Folienleiterplatte mit einer im erfindungsgemässen Verfahren strukturierten Abdeckung.
- Fig.34-37: zeigen eine weitere Variante des erfindungsgemässen Verfahrens mit mechanischer Strukturierung von Abdeckungen auf einem Teil einer Folienleiterplatte.

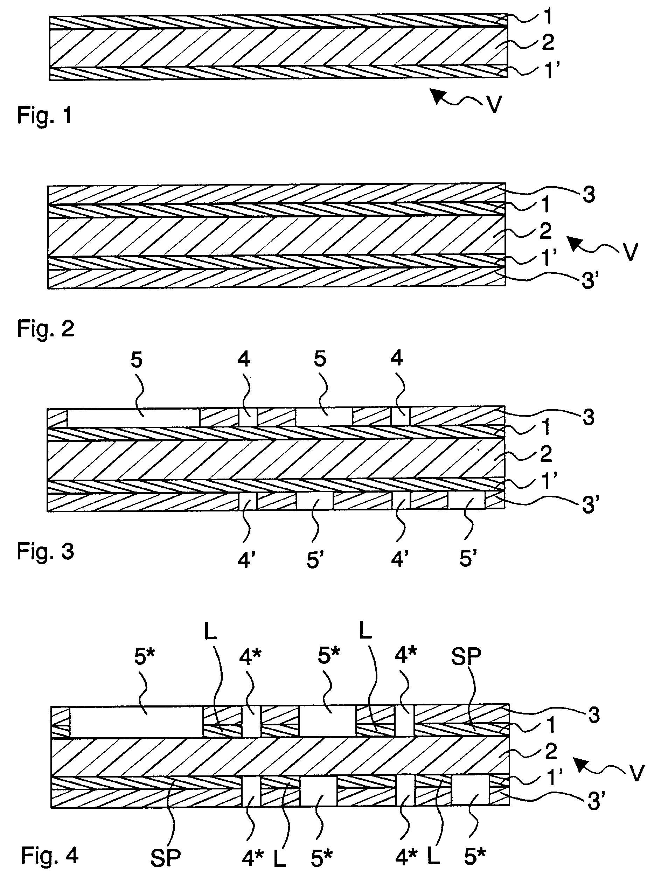

In den **Figuren 1** bis **8** sieht man eine Variante des erfindungsgemässen Verfahrens der photochemischen Strukturierung von Strompfaden und Lötaugen auf einem Teil eines Ausgangsmaterials und der mechanischen Strukturierung von Durchplattierungen gemäss Maskenfolien. Das Ausgangsmaterial und die Verfahrensschritte sind in diesen Figuren in einem Schnitt entlang der flächigen Ausdehnung des Ausgangsmaterials dargestellt. Die herzustellenden Durchplattierungen sollen mindestens zwei voneinander durch eine Schicht Isolator oder Kunststoff getrennte, elektrisch leitende Schichten oder Leiterschichten miteinander verbinden. Die Durchplattierungen durchdringen also alternierend zwischen Leiterschichten angeordnete, intermediäre Isolatorschichten und verbinden jeweils mindestens zwei solcher Leiterschichten. Die Durchplattierungen müssen nicht senkrecht zur Oberfläche der zu durchdringenden Kunststoffschicht verlaufen, sie können auch schräg durch sie hindurchgehen. Für das erfindungsgemässe Verfahren ist die Strukturierung von Lötaugen in Leiterschichten nicht notwendig.

**Figur 1** zeigt ein Ausgangsmaterial V des Verfahrens. Vorteilhafterweise wird ein mehrlagiges Ausgangsmaterial V verwendet, das beispielsweise aus einer doppelseitig mit elektrisch leitenden Schichten oder Leiterschichten 1,1' kaschierten Isolatorschicht oder Kunststoff-Folie 2 besteht. Als Leiterschichten 1,1' können Kupferfolien, als Isolatorschichten 2 können geeignete Kunststofffolien, beispielsweise Polyimidfolien oder Epoxydfolien verwendet werden. Anstelle von Kupferfolien können auch kalt laminierte Kompositfolien bestehend aus einer dickeren Aluminiumfolie und beidseitig darauf laminierten, dünneren Kupferfolien. Ebenfalls geeignete Ausgangsprodukte sind beispielsweise Folien aus rostfreiem Stahl, Messing, Bronze, Aluminium-Magnesium-Legierungen, Invar, Molybdän etc. Diese Leiterschichten 1,1' und die Kunststoff-Folie 2 sind 3 bis 100 µm dick. Das Ausgangsmaterial V kann starr oder flexibel sein.

**Figur 2** zeigt wie das Ausgangsmaterial V gemäss Figur 1 beidseitig mit Photoresist 3,3' beschichtet wird. Die Leiterschichten 1,1' sind vollständig mit Photoresist 3,3' bedeckt. Es kann festes oder flüssiges Photoresist verwendet werden. Die Schichten Photoresist 3,3' können in bekannten photochemischen Verfahren belichtet werden, wodurch Leiterbildstrukturen und Durchplattierungsstrukturen über eine Photomaske übertragen werden.

**Figur 3** zeigt diese photochemisch durchgeführte Strukturierung der Schichten Photoresist 3,3'. In der strukturierten Schicht Photoresist 3 sind Leiterbildstrukturen 5 und Durchplattierungsstrukturen 4 angebracht, in der strukturierten Schicht Photoresist 3' sind Leiterbildstrukturen 5' und Durchplattierungsstrukturen 4' angebracht. Diese Strukturen reichen bis auf die Leiterschichten 1,1' herab. Der Durchmesser der Durchplattierungsstrukturen 4,4' beträgt typischerweise 25 bis 100 µm. Diese Strukturen 4,4',5,5' sind frei wählbar, sie können kreiszylindrische, runde, ovale und auch quadratische, rechteckige, mehreckige Duchmesser aufweisen. Die Leiterbildstrukturen 5,5' und die Durchplattierungsstrukturen 4,4' dienen zur Übertragung des Schaltungsentwurfs (Strompfade, Lötaugen, etc.) und der Informationen bezüglich Position und Struktur der herzustellenden Durchplattierungen in den Leiterschichten 1,1'. In den Bereichen, wo sich Photoresist 3,3' befindet, wird in den folgenden Verfahrensschritten kein elektrisch leitendes Material der Leiterschichten 1,1' entfernt.

**Figur 4** zeigt das derart photochemisch strukturierte Ausgangsmaterial V nach erfolgtem nasschemischen Ätzen des von Photoresist 3,3' unbedeckten Materials der Leiterschichten 1,1'. Dieses Ätzen führt zum gezielten Entfernen einzelner Bereiche der Leiterschichten 1,1'. Hierdurch werden durch Isolierbereiche 5* getrennte Strompfade SP, Lötaugen L und Durchplattierungsbereiche 4' gebildet. Das nasschemische Ätzen findet gezielt in der Tiefe statt, d.h. die Leiterschichten 1,1' werden in von Photoresist 3,3' unbedeckten Bereichen bis auf die Kunststoff-Folie 2 herunter entfernt. Das nasschemische Ätzen findet in allen exponierten Bereichen (d.h. die Bereiche die für die ätzenden Chemikalien und Flüssigkeiten zugänglich sind) gleichzeitig statt.

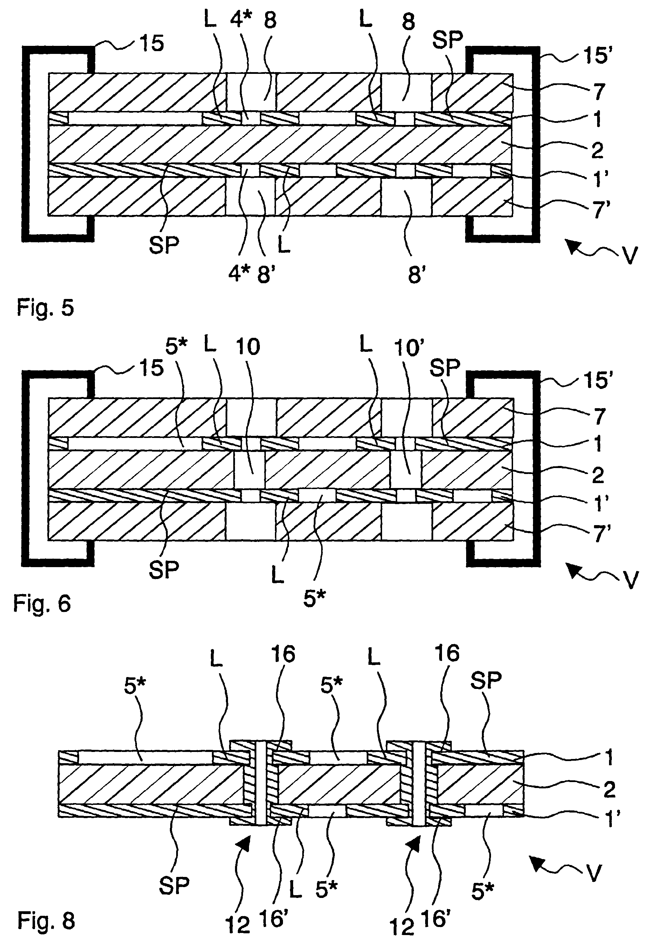

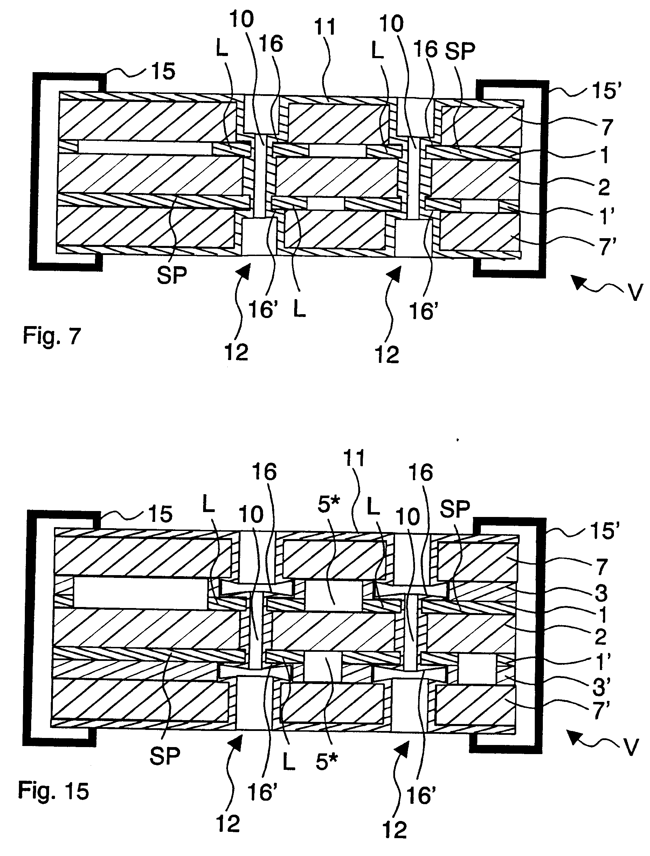

**Figur 5** zeigt das sich im Herstellungsstadium gemäss Figur 4 befindliche Ausgangsmaterial V nach Entfernen (Strippen) der Schichten Photoresist 3,3'. Dies geschieht mittels bekannter und bewährter chemischer Prozesse. Zwei dünne Maskenfolien 7,7', beispielsweise rostfreie Stahlfolien, mit einer Dicke kleiner 100 µm sind auf den strukturierten Leiterschichten 1,1' reversibel angebracht worden. Sie werden mittels Klammern 15,15' fixiert und können durch Lösen derselben wieder entfernt werden. Das Fixieren ist ein dichtes Anpressen. Die Positionierung der Maskenfolien 7,7' geschieht auf bekannte Art und Weise, beispielsweise mittels Registrierbolzen. D.h. auf dem Ausgangsmaterial V und den Maskenfolien 7,7' sind besonders geformte Markierungen angebracht, die beispielsweise in Deckung miteinander gebracht werden, wodurch eine kontrollierte Positionierung derselben geschieht.

Die Maskenfolien 7,7' sind durch Formätzen strukturiert und weisen Durchgangsöffnungen 8,8' auf. Diese werden fluchtend mit Durchplattierungsbereichen 4 der Leiterschichten 1,1' positioniert. Die Aussendurchmesser der Durchgangsöffnungen 8,8' sind grösser als die Aussendurchmesser der Durchplattierungsbereiche 4* der Leiterschichten 1,1' aber sie sind kleiner als die Aussendurchmesser der um diese Durchplattierungsbereiche 4* angebrachten Lötaugen L. Das Formätzen der Durchgangsöffnungen 8,8' findet in einem gesonderten, hier nicht gezeigten, bekannten Herstellungsverfahren statt. Es können beliebige Formen und Strukturen, wie runde und eckige Öffnungen, längliche gerade und gebogene Öffnungen etc. verwendet werden. Die Durchgangsöffnungen 8,8' sind auch deshalb grösser gearbeitet als die Durchplattierungsbereiche 4*, um allfällige Dimensionsänderungen der Kunststoff-Folie 2 auszugleichen. Vorteilhafterweise verwendet man Durchgangsöffnungen mit einem günstigsten Aussendurchmesser D_{g} für eine optimalste Dimensionierung bei minimalem Platzverbrauch. Dieser berechnet sich aus dem Aussendurchmesser der Lötaugen L minus dem Aussendurchmesser der Durchplattierungsbereiche 4* dividiert durch zwei.

Das dichte Anpressen der Maskenfolien 7,7' auf das Ausgangsmaterial V wird dadurch erleichtert, dass die Maskenfolien 7,7' leicht konkav geformt sind, derart, dass sie sich an ihren Rändern leicht nach aussen, von der flächigen Ausdehnung des Ausgangsmaterials V wegbiegen, sodass durch das Befestigen mittels der Klammern 15,15' Biegekräfte generiert werden, welche ein verwackel- und verrückungsfreies Aufliegen der Maskenfolien 7,7' auf dem Ausgangsmaterial V zur Bildung von Folienpaketen gewährleisten. Dies ist wichtig, da diese so gebildeten Folienpakete transportiert werden müssen, beispielsweise für das Plasma-Ätzen in und wieder aus den Plasma-Reaktor.

**Figur 6** zeigt ein Folienpaket gemäss Figur 5 nach dem Plasma-Ätzen der Durchplattierungsöffnungen 10 in der Kunststoff-Folie 2. Die Durchplattierungsöffnungen 10 werden an der Position der Durchgangsöffnungen 8,8' der Maskenfolien 7,7' geätzt. Die Durchplattierungsöffnungen 10 sind bewusst hinterätzt, d.h. sie werden entlang der flächigen Ausdehnung des Ausgangsmaterials V unter die Ränder der beispielsweise in Lötaugen L oder Strompfade SP strukturierten Leiterschichten 1,1' geätzt. Andere Bereiche freigelegter Kunststoff-Folie 2, beispielsweise die Isolierbereiche 5*, werden durch die Maskenfolien 7,7' vor dem Plasma-Angriff geschützt.

**Figur 7** zeigt ein plasma-geätztes Folienpaket gemäss Figur 6 nach Aufplattierung einer Kontaktschicht 11 aus einem elektrisch leitenden Material, beispielsweise aus Kupfer. Bei diesem bekannten und bewährten chemischen und galvanischen Prozess werden die Maskenfolien 7,7' und die Durchplattierungsöffnungen 10 des Ausgangsmaterials V mit einer Kontaktschicht 11 überzogen, derart, dass die Durchplattierungsöffnungen 10 durchplattiert werden. Das elektrisch leitende Material wird elektrochemisch abgeschieden und aufplattiert. Durchplattierte Öffnungen 10 werden als Durchplattierungen 12 bezeichnet. Diese abgeschiedene Kontaktschicht 11 ist dünn und weist Dicken kleiner 25 µm auf Die Durchplattierungen 12 haben über Verbindungsbereiche 16,16' elektrischen Kontakt mit Lötaugen L, Strompfaden SP und den Maskenfolien 7,7'. Nach Entfernen der Maskenfolien 7,7' ist eine Ausführungsform einer zweilagige Folienleiterplatte erfindungsgemäss bergestellt.

**Figur 8** zeigt die zweilagige Folienleiterplatte gemäss Figur 7 nach Entfernen der Maskenfolien 7,7'. Das Entfernen der Maskenfolien 7,7' ist bei dünnen aufplattierten Kontaktschichten 11 mit Dicken kleiner 10 µm problemlos, nach Lösen der Klammern 15,15' können diese abgezogen werden. Zur Herstellung von Folienleiterplatten mit mehr als zwei Lagen Leiterschichten 1,1' wird beispielsweise eine solche zweilagige Folienleiterplatte mit weiteren Isolator- und Leiterschichten versehen und durch Wiederholung des erfindungsgemässen Verfahrens in der ersten Variante gemäss den Figuren 1 bis 8 photochemisch und mechanisch strukturiert. Hierbei ist die mit Isolator- und Leiterschichten versehene zweilagige Folienleiterplatte wiederum ein Ausgangsmaterial V. Es werden immer solche Bereiche des Ausgangsmaterials V strukturiert, die für Licht, Chemikalien, Flüssigkeiten (von aussen) zugänglich sind und an denen sich Maskenfolien positionieren lassen. Dem Fachmann stehen hierbei bei Kenntnis dieser Erfindung viele Variationsmöglichkeiten offen.

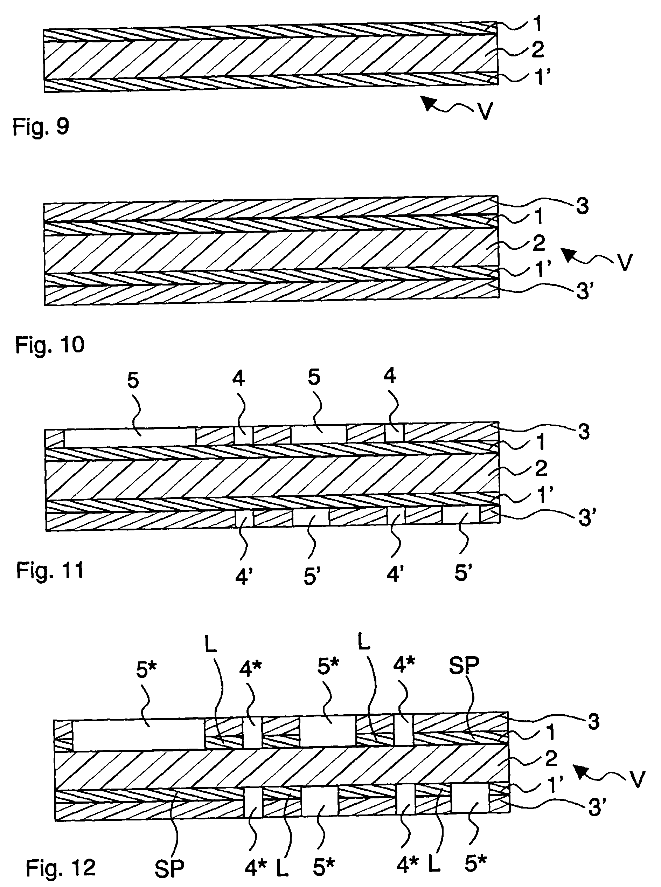

Die Dicke der Kontaktschichten 11 ist ein kritischer Parameter. Bei dickeren Kontaktschichten 11 kann es in den Verbindungsbereichen 16,16' zur unkontrollierten Trennung der Maskenfolien 7,7' vom Ausgangsmaterial V kommen. Dies kann zu Abrissen von Bereichen aufplattierter Kontaktschichten 11 und beispielsweise zu Beschädigungen von Durchplattierungen 12 durch Unterbruch von elektrischen Kontakten zu Lötaugen L oder Strompfaden SP führen. Solche unerwünschten Abrisse aufgrund kräftig aufplattierter Verbindungen zwischen dem Ausgangsmaterial V und den Maskenfolien 7,7' werden in den weiteren Varianten des erfindungsgemässen Verfahrens gemäss den Figuren 9 bis 27 vermieden.

Die Maskenfolien 7,7' sind wiederverwertbare Betriebsmittel, da sie - nach Entfernen der aufplattierten Kontaktschicht 11 - wieder eingesetzt werden können. In vorteilhaften Ausführungsformen sind die Maskenfolien 7,7' polierte Metallfolien von denen sich aufplattierten Kontaktschicht 11 durch einfaches Ablösen wieder entfernen lassen. Das Entfernen der Kontaktschicht 11 von den Maskenfolien 7,7' kann auch durch chemisches Abätzen geschehen.

Verbleiben zwischen Ausgangsmaterial V und den Maskenfolien 7,7' nach deren gegenseitiger Fixierung Verunreinigungen, beispielsweise ein Staubkorn, so können die Maskenfolien 7,7' in solchen Bereichen nicht flächig auf dem Ausgangsmaterial V liegen und es können sich kleine Hohlräume zwischen diesen auftun. Solche Hohlräume können einmal beim Plasma-Ätzen oder ein andermal beim Aufplattieren für das Ätz-Medium und respektive Chemikalien und Flüssigkeiten zugänglich sein, was aber nicht weiter störend ist oder auf einfache Art und Weise behoben werden kann. Zum einen ist die Ätzrate in engen Hohlräumen praktisch Null, da nur geringe Mengen Ätz-Medium in diese eindringen können und schlecht erneuert werden. Zum anderen kann das Eindringen von Chemikalien und Flüssigkeiten beim Aufplattieren in solche Hohlräume durch vorheriges Füllen der Hohlräume mit einer unschädlichen Flüssigkeit, beispielsweise mit Wasser, vermieden werden.

In den **Figuren 9** bis **17** sieht man eine weitere Variante des erfindungsgemässen Verfahrens der photochemischen Strukturierung von Strompfaden und Lötaugen auf einem Teil eines Ausgangsmaterials und der mechanischen Strukturierung von Durchplattierungen. Das Ausgangsmaterial und die Verfahrensschritte sind in diesen Figuren in einem Schnitt entlang der flächigen Ausdehnung des Ausgangsmaterials dargestellt. Der Verfahrensablauf dieser Variante folgt weitgehend demjenigen der Variante in der Beschreibung gemäss den Figuren 1 bis 8, sodass im folgenden nur Abweichungen erläutert werden.

Der prinzipielle Unterschied zwischen der ersten und zweiten Variante des erfindungsgemässen Verfahrens ist der, dass in der zweiten Variante der Photoresist 3,3' vor dem Anbringen der Maskenfolien 7,7' nicht gestrippt, sondern auf dem Ausgangsmaterial V belassen wird. Die Verfahrensschritte gemäss den **Figuren 9** bis **12** sind demnach identisch mit denjenigen der Figuren 1 bis 4.

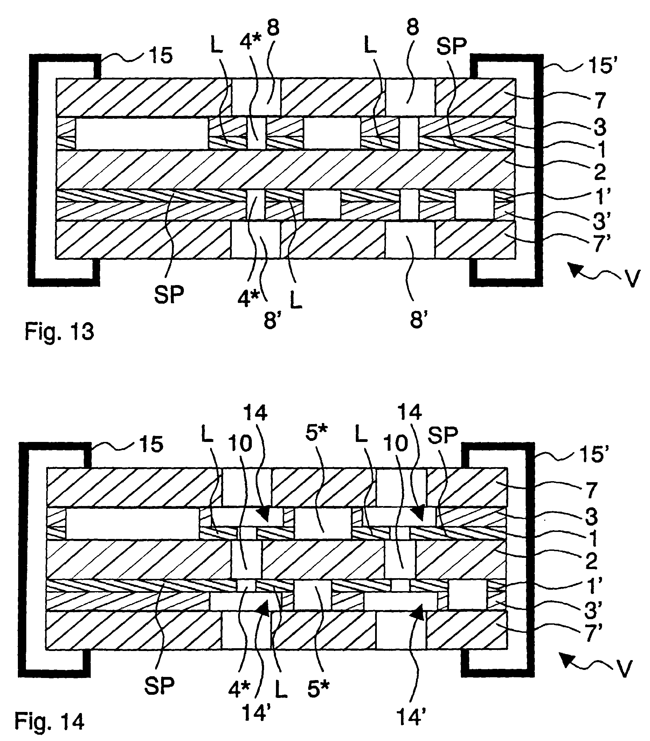

**Figur 13** zeigt das sich im Herstellungsstadium gemäss Figur 4 befindliche Ausgangsmaterial V, auf welches zwei dünne Maskenfolien 7,7' mittels Klammern 15,15' reversibel direkt auf dem Photoresist 3,3' angebracht worden sind. Die Maskenfolien 7,7' besitzen Durchgangsöffnungen 8,8', welche mit den Durchplattierungsbereichen 4* in Deckung gebracht werden und einen grösseren Durchmesser als diese aufweisen.

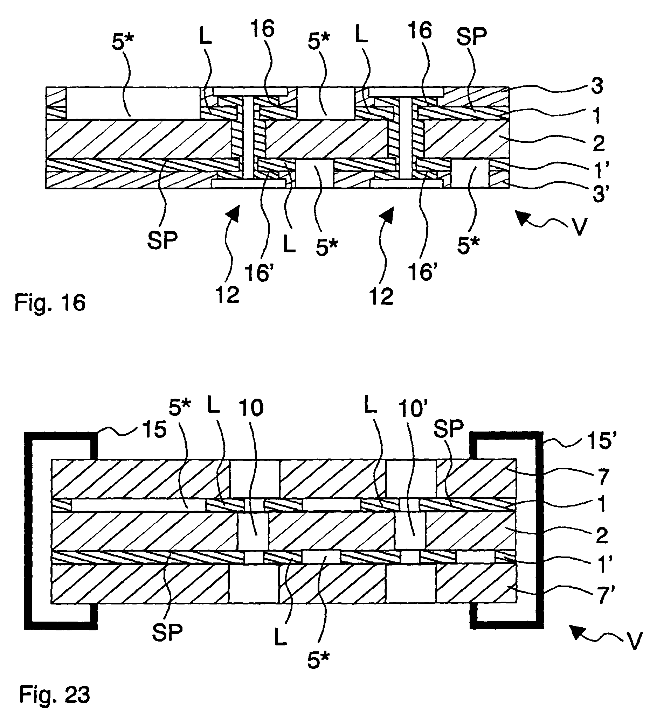

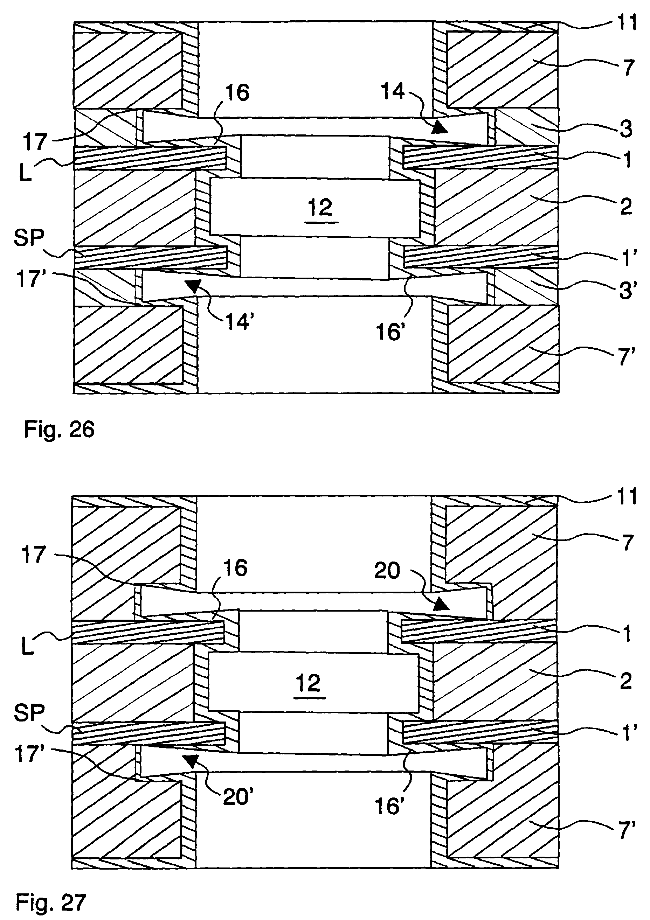

Die **Figuren 14** und **15** zeigen die Verfahrensschritte des Plasma-Ätzens und des Aufplattierens der weiteren Variante, die weitgehend mit den korrespondierenden Verfahrensschritten der Variante gemäss den Figuren 6 und 7 übereinstimmen. Beim Plasma-Ätzen werden die Durchplattierungsöffnungen 10 geätzt und das freiliegende Photoresist 3,3' hinterätzt. Diese hinterätzten Bereiche 14,14' bilden vorgeprägte lokale Schwachstellen 17,17' der aufplattierten Kontaktschicht 11 in Ablösebereichen zwischen dem Ausgangsmaterial V und den Maskenfolien 7,7'. Die Hinterätzungen im Photoresist 3,3' werden lokal gezielt aufplattiert, wodurch einerseits gute, stark ausgebildete, stabile Verbindungsbereichen 16,16' der Durchplattierungen 12 mit den Lötaugen L und den Strompfaden SP entstehen, und andererseits lokale Schwachstellen 17,17' der Durchplattierungen 12 mit den Maskenfolien 7,7' entstehen, sodass die Maskenfolien 7,7' auch bei Applikation dickerer Kontaktschichten 11 mit Dicken grösser 10 µm ohne Beschädigungen des Ausgangsmaterials V im Bereichen der Durchplattierungen 12 entfernt werden können. Diese erste Ausführungsform lokaler Schwachstellen 17,17' wird in der Beschreibung gemäss Figur 26 detailliert beschrieben.

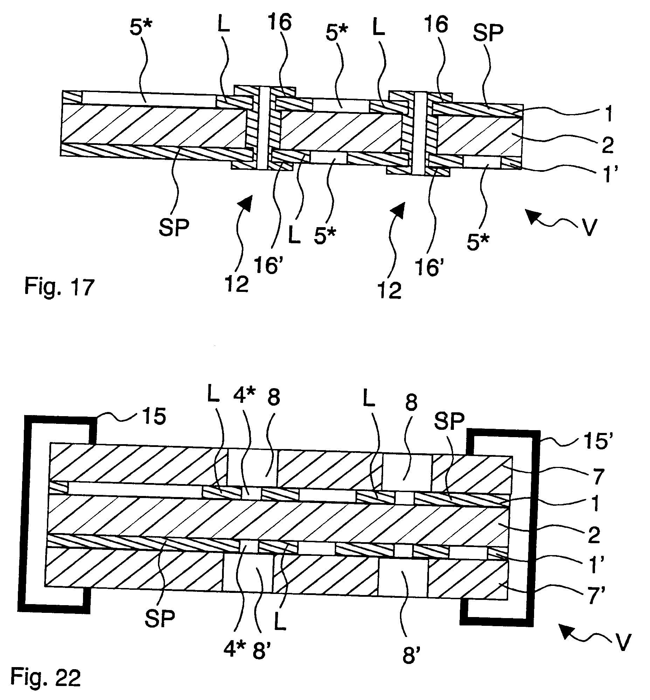

Die **Figuren 16** und **17** zeigen das Ausgangsmaterial V nach dem Entfernen der Maskenfolien 7,7' durch Lösen der Klammern 15,15' und Abziehen der Maskenfolien 7,7' (siehe Figur 16) und nach dem konventionellen Strippen des restlichen Photoresists 3,3' (siehe Figur 17).

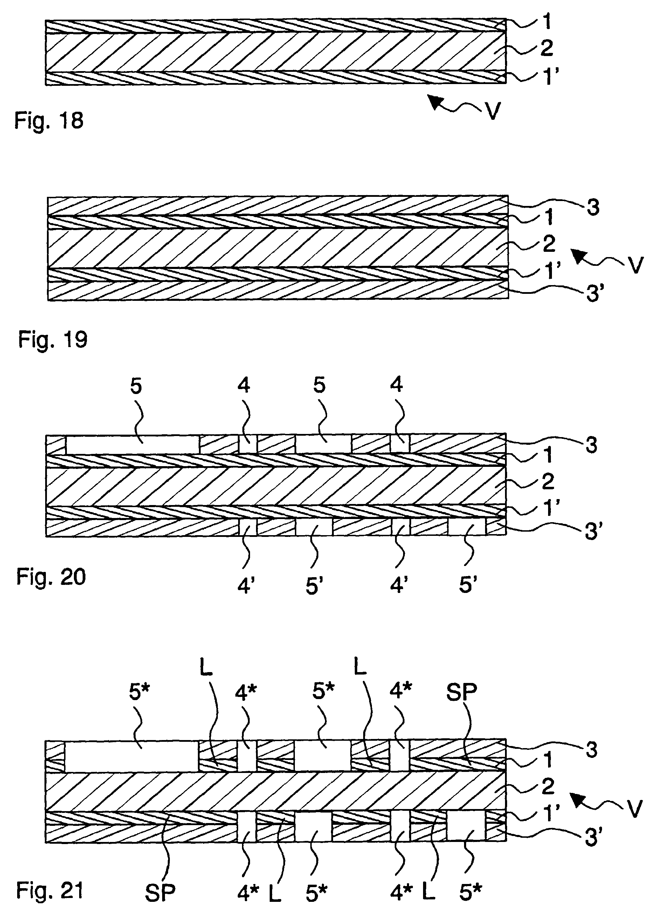

In den **Figuren 18** bis **25** sieht man eine weitere Variante des erfindungsgemässen Verfahrens der photochemischen Strukturierung von Strompfaden und Lötaugen auf einem Teil eines Ausgangsmaterials und der mechanischen Strukturierung von Durchplattierungen mit Maskenfolien. Das Ausgangsmaterial und die Verfahrensschritte sind in diesen Figuren in einem Schnitt entlang der flächigen Ausdehnung des Ausgangsmaterials dargestellt. Der Verfahrensablauf dieser dritten Variante folgt weitgehend denjenigen der Varianten in den Beschreibungen gemäss den Figuren 1 bis 8 und respektive Figuren 9 bis 15, sodass im folgenden Abweichungen hiervon erläutert werden.

Der prinzipielle Unterschied zur Variante gemäss den Figuren 1 bis 8 liegt darin, dass in der dritten Variante eine elektrisch leitfähige Abscheidesubstanz, beispielsweise ein Metall wie Nickel oder Gold, aufgrund chemischer Potentialdifferenzen abgeschieden wird. Die Verfahrensschritte gemäss den **Figuren 18** bis **23** sind identisch mit denjenigen der Figuren 1 bis 6.

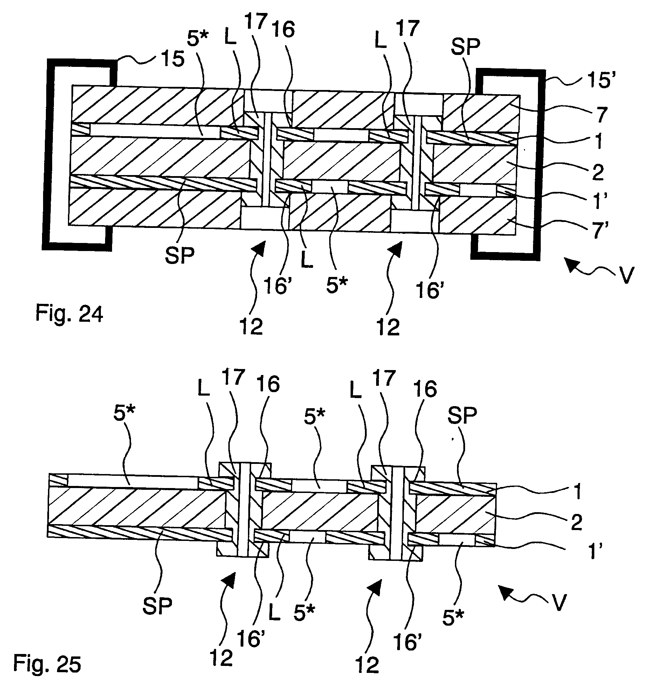

**Figur 24** zeigt das sich im Herstellungsstadium gemäss den Figuren 23 oder 6 befindliche Folienpaket mit Durchplattierungen 12. Hierbei wird die Differenz des chemischen Potentials zwischen den beteiligten leitfähigen Materialien bewusst ausgenutzt, um lediglich die Durchplattierungsöffnungen 10 im Bereich der Strompfade SP und Lötaugen L und der Kunststoff-Folie 2 mit einer Kontaktschicht 11 zu bedecken, um so die Durchplattierungen 12 herzustellen. Wurden beispielsweise die Strompfade SP und Lötaugen L aus Kupferfolien strukturiert, so können auf dem Ausgangsmaterial V in einem Nickel- oder Goldbad eine dünne Schicht Nickel oder Gold chemisch abgeschieden werden. Im erfindungsgemässen Verfahren wird dies ausgenutzt, um Durchplattierungen 12 in den Durchplattierungsöffnungen 10 zu bilden, welche über Verbindungsbereiche 16,16' mit Strompfaden SP und Lötaugen L elektrisch kontaktierbar sind, ohne dass kräftige Verbindungen zu den Maskenfolien 7,7' entstehen.

Dies wird durch ein örtlich gezieltes Abscheiden von Metall durchgeführt. Steuerbar ist dieser Vorgang aufgrund der chemischen Potentialdifferenzen zwischen den benutzten Materialien. Verwendet man als Maskenfolien 7,7' beispielsweise rostfreie Stahlfolien und als Abscheidesubstanzen, beispielsweise Metalle wie Nickel oder Gold, so wird auf den rostfreien Stahlfolien eine sehr geringe Menge Nickel oder Gold von wenigen µm Dicke abgeschieden, sodass sich keine kräftigen Verbindungen zwischen dem Ausgangsmaterial V und den rostfreien Stahlfolien bilden und somit auch keine Beschädigungen dem Ausgangsmaterial V beim Entfernen der rostfreien Stahlfolien verursacht werden. Verwendet man als Maskenfolien 7,7' vergoldete rostfreie Stahlfolien, so scheidet sich auf diesen, bei Verwendung von Nickel als Abscheidesubstanz, aufgrund deren günstiger chemischer Potentialdifferenz überhaupt kein Nickel ab. Nickel oder Gold lassen sich auf Kupfer chemisch aber sehr gut abscheiden, und bei entsprechender Aktivierung lassen sie sich auch auf der Kunststoff-Folie 2 chemisch abscheiden. Derart lassen sich Folienleiterplatten mit plasma-geätzten Durchplattierungen 12 von Durchmessern kleiner 100 µm aus abgeschiedenen Kontaktschichten 11 dünner 25 µm herstellen.

Die **Figur 25** zeigt das Ausgangsmaterial V nach dem Entfernen der Maskenfolien 7,7' durch Lösen der Klammern 15,15' und Abziehen der Maskenfolien 7,7'. Weil die Verbindungen zwischen dem Ausgangsmaterial V und den Maskenfolien 7,7' sehr dünn (kleiner 10 µm) sind oder nicht existieren, treten bei diesem Vorgang keine Beschädigungen des Ausgangsmaterials V durch Abrisse in den Verbindungsbereichen 16,16' auf.

Die **Figuren 26** und **27** zeigen zwei Ausführungsformen lokaler Schwachstellen 17,17 im Ablösebereich des Ausgangsmaterials V von den Maskenfolien 7,7'. Man sieht nur einen Teil des Ausgangsmaterials V nach den Verfahrenschritten des Plasma-Ätzens der Durchgangsöffnungen 10 und dem Abscheiden elektrisch leitfähiger Kontaktschichten 11.

Die Ausführungsform lokaler Schwachstellen 17,17' im Ablösebereich in **Figur 26** zeigt eine detaillierte Vergrösserung der gemäss den Figuren 9 bis 17 beschriebenen Variante des erfindungsgemässen Verfahrens, wo das Photoresist 3,3' nach durchgeführter Strukturierung der Leiterbildstrukturen 5,5' und der Durchplattierungsstrukturen 4,4' vor dem Anbringen der Maskenfolien 7,7' nicht entfernt (gestrippt) wird, sondern auf dem Ausgangsmaterial V verbleibt, und wo dieses Photoresist 3,3' im Verfahrensschritt des Plasma-Ätzens in Bereichen 14,14' bewusst hinterätzt wird. Diese derart hinterätzten Bereiche 14,14' vorgeprägte lokale Schwachstellen der aufplattierten Kontaktschicht 11 in Ablösebereichen zwischen dem Ausgangsmaterial V und den Maskenfolien 7,7' bilden. Die Hinterätzungen im Photoresist 3,3' werden lokal gezielt mit Metall aufplattiert, wodurch einerseits gute, stark ausgebildete, stabile Verbindungsbereiche 16,16' der Durchplattierungen 12 mit den Lötaugen L und den Strompfaden SP entstehen, aber andererseits nur lokale Schwachstellen 17,17' der Durchplattierungen 12 mit den Maskenfolien 7,7' gebildet werden, sodass die Maskenfolien 7,7' auch bei Applikation dickerer Kontaktschichten 11 mit Dicken grösser 10 µm, ohne Beschädigungen des Ausgangsmaterials V im Bereich der Durchplattierungen 12 entfernt werden können.

Diese lokalen Schwachstellen 17,17' werden beim Aufplattieren des hinterätzten Photoresists 3,3' in den Durchplattierungsöffnungen 12 gebildet. Dadurch dass sich dass hinterätzte Photoresist 3,3' am Ende der hinterätzten Bereiche 14,14' befindet (die ja enge Spalte sind), dass bei diesem Verfahrensschritt wenig Chemikalien und Flüssigkeiten in diese engen hinterätzten Bereich 14,14' eindringen, und dass während der chemischen und galvanischen Belegung elektrisch leitfähigesn Material wie Metall bevorzugt auf den Leiterschichten 1,1' und den metallischen Maskenfolien 7,7' abgeschieden wird, wird auf dem Photoresist 3,3' nur eine geringe Menge Metall abgeschieden, sodass sich hier lokal dünne Kontaktschichten 11 bilden, welche lokale Schwachstellen 17,17' im kritischen Ablösebereich darstellen.

Die weitere Ausführungsform lokaler Schwachstellen 17,17' im Ablösebereich in **Figur 27** zeigt eine Folienleiterplatte die nach den Varianten des erfindungsgemässen Verfahrens gemäss den Figuren 1 bis 8 oder den Figuren 18 bis 25 hergestellt wurde. In dieser zweiten Ausführungsform werden lokale Schwachstellen 17,17' durch spezielle, vorteilhafte und günstige Formen der Durchgangsöffnungen 8,8' der Maskenfolien 7,7' induziert. Die Maskenfolien 7,7' gemäss Figur 27 besitzen Durchgangsöffnungen 8,8' mit Ausformungen 20,20', welche nach Aufbringen derselben auf das Ausgangsmaterial V enge Hohlräume im Bereich der Verbindung zwischen Ausgangsmaterial V und den Maskenfolien 7,7' ausbilden. In diesen, durch Ausformungen 20,20' gebildeten engen Hohlräumen, wird lokal gezielt elektrisch leitfähiges Material abgeschieden, um so lokal Schwachstellen 17,17' der chemisch und galvanisch abgeschiedenen Kontaktschicht 11 in den Ablösebereichen zwischen dem Ausgangsmaterial V und den Maskenfolien 7,7' herzustellen. Auch hier bieten sich wieder mehrere Möglichkeiten des Abscheidens von beispielsweise Metall an. Zum einen entstehen lokal dünne Kontaktschichten 11 in diesen Hohlräumen, da eine geringe Menge Chemikalien und Flüssigkeiten in die engen Hohlräume eindringen können, sodass sich hier nur dünne Kontaktschichten 11 bilden, welche lokale Schwachstellen 17,17' im kritischen Ablösebereich darstellen. Zum anderen muss nicht chemisch und galvanisch (wie in der Variante gemäss den Figuren 1 bis 8) abgeschieden werden, sondern man kann Metall zur Bildung von Maskenschichten 11 auch rein chemisch abscheiden (wie in der Variante gemäss den Figuren 18 bis 25). In diesem Fall wird aufgrund chemischer Potentialdifferenzen zwischen den verwendeten Materialien ein örtlich gezieltes Abscheiden von Metall durchgeführt. Dies wird in der Beschreibung der Variante gemäss den Figuren 18 bis 25 erläutert.

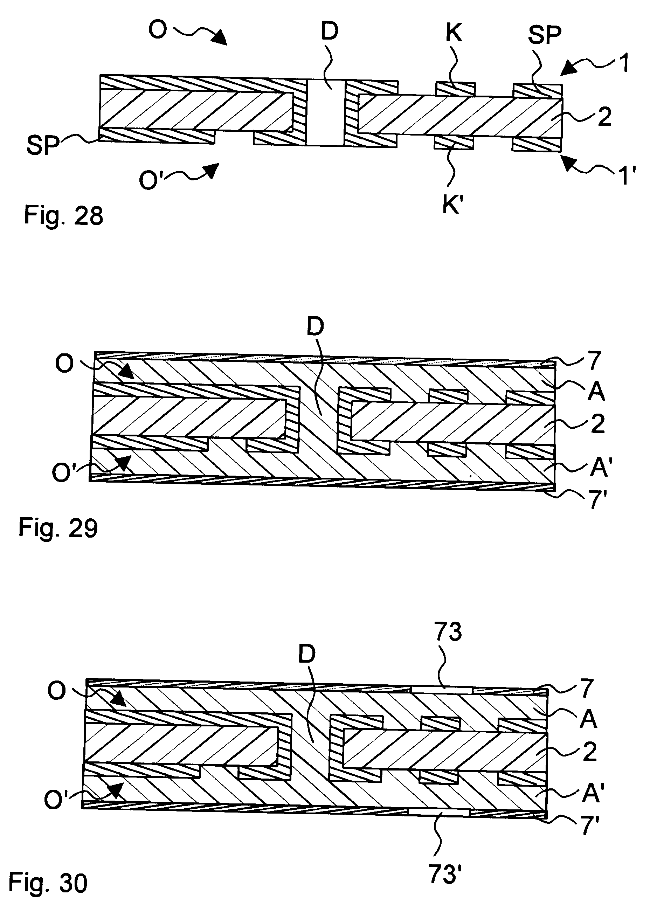

Die **Figuren 28** bis **32** zeigen eine weitere Variante des erfindungsgemässen Verfahrens mit mechanischer Strukturierung von Abdeckungen auf einem Teil einer Folienleiterplatte. Dies erfolgt in einem Schnitt entlang der flächigen Ausdehnung der Folienleiterplatte.

**Figur 28** zeigt eine beispielsweise zweilagige Folienleiterplatte, die aus in zwei Lagen elektrisch leitender Schichten oder Leiterschichten 1,1' angeordneten Strompfade SP und Kontaktstellen K,K' besteht, die durch eine Isolatorschicht 2 voneinander elektrisch isoliert sind. Die beiden Oberflächen mit flächiger Ausdehnung der Folienleiterplatte werden als Oberflächen O,O' bezeichnet. Die Strompfade SP verschiedener Leiterschichten 1,1' können über Durchplattierungen D in elektrischem Kontakt miteinander stehen. Ziel des Anbringens einer strukturierten Abdeckung ist es nun, die Kontaktstellen K,K' der Folienleiterplatte abdeckungsfrei zu halten, um diese später mit Bauelementen bestücken zu können, während beispielsweise die Strompfade SP und isolierende Oberflächenbereiche der Isolatorschicht 2 abgedeckt werden sollen, um diese so vor mechanischer Beschädigung oder vor Korrosion metallischer Strompfade zu schützen.

**Figur 29** zeigt wie auf die Oberflächen O,O' solche Folienleiterplatte Abdeckungen bestehend aus Abdeckschichten A,A' und Maskenfolien 7,7' angebracht werden. Die Abdeckschichten A,A' bestehen beispielsweise aus Polyimid- oder Epoxid-Folien und aus Epoxid-Harz beschichteten Polyimid-Folien. Letztere verwendet man beispielsweise um Polyimid-Folien mittels Schichten nicht ausgehärteten Epoxid-Harzes mit Maskenfolien 7,7' oder Folienleiterplatten, etc, zu verbinden. Die Maskenfolien 7,7' bestehen beispielsweise aus Leiteren wie Kupfer, rostfreiem Stahl, Messing, Bronze, Aluminium-Magnesium-Legierungen, Invar, Molybdän, etc.

Solche Epoxid-Harz beschichtete Polyimid-Folien können also entlang ihrer flächigen Ausdehnung auf der einen Seite mit Kupferfolien auflaminiert und auf der anderen Seite auf Folienleiterplatten auflaminiert werden. Dies findet vorteilhafterweise im gleichen Verpressvorgang bei Druck und erhöhter Temperatur statt. Diese Materialien sind nach dem Aushärten des Epoxid-Harzes weiterhin sehr flexibel und sind daher generell als Abdeckungen für flexible Schaltungsträger einsetzbar. Sie sind günstig im Einkauf, wodurch das Verfahren kostengünstig betrieben werden kann. Abdeckschichten A,A' können auf beiden Seiten der Folienleiterplatte simultan auflaminiert werden, was bei den meisten oben genannten Verfahren mit Lötstopp-Lacken nicht möglich ist. Diese müssen einseitig aufgetragen und getrocknet werden, bevor die zweite Seite bearbeitet werden kann (eine Ausnahme hiervon ist das teure elektrophoretische Verfahren).

Die Durchplattierungen D der Folienleiterplatte werden beim Auflaminieren mit beispielsweise Epoxid-Harz beschichteten Polyimid-Folien gefüllt, wodurch auch diese Leiterbahnen geschützt werden. Die Dicken solcher Kupferfolien und Epoxid-Harz beschichteter Polyimidfolien sind kleiner 100 µm.

**Figur 30** zeigt die auf den Abdeckschichten A,A' und der Folienleiterplatte angebrachte Maskenfolien 7,7' gemäss Figur 29 nach photochemischer Strukturierung dieser Maskenfolien 7,7' in Kontaktierstrukturen 73,73'. Dies geschieht mit bekannten photochemischen Verfahren, wobei die Kontaktierstrukturen 73,73' gemäss einer Photomaske in die Maskenfolien 7,7' übertragen werden. Die Kontaktierstrukturen 73,73' reichen bis auf die Abdeckschichten A,A' herab. Es werden somit maskenmaterialfreie (kupferfreie) Bereiche auf den Abdeckschichten A,A' gebildet. Die Form dieser Kontaktierstrukturen 73,73' sind frei wählbar, sie können beispielsweise kreiszylindrische, runde, ovale und auch quadratische, rechteckige, mehreckige Duchmesser aufweisen.

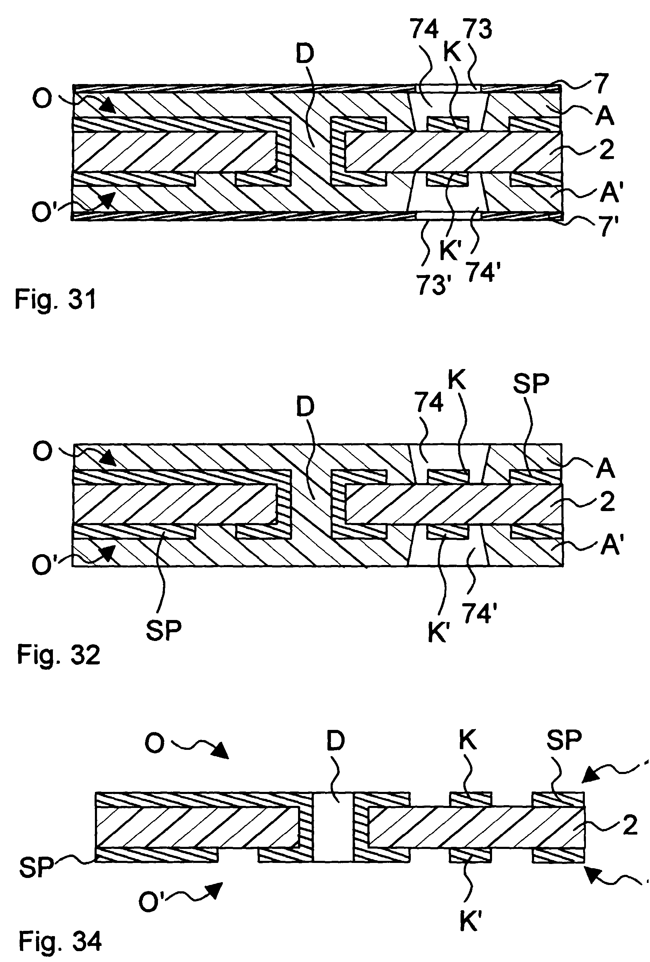

**Figur 31** zeigt die auf der Folienleiterplatte angebrachten Maskenfolien 7,7' gemäss Figur 30 nach mechanischer Strukturierung dieser Abdeckschichten A,A' in Abdecköffnungen 74,74'. Diese Abdecköffnungen 74,74' werden in einem Plasma-Ätz-Vorgang in den von Kupfer ungeschützten Bereichen, gemäss den Kontaktierstrukturen 73,73' der Maskenfolien 7,7' geätzt. Ansonsten schützen die Maskenfolien 7,7' die Abdeckschichten A,A' vor dem Plasma-Angriff, sodass dort keine Ätzung der Abdeckschichten A,A' stattfindet. Die Ränder der Kontaktierstrukturen 73,73' der Maskenfolien 7,7' werden hinterätzt, die Abdecköffnungen 74,74' weisen schräge Wandungen auf. Die Abdecköffnungen 74,74' in den Abdeckschichten A,A' werden bis auf die Oberflächen O,O' der Folienleiterplatte hinunter plasma-geätzt. Alle diese Kontaktierstrukturen 73,73' der Maskenfolien 7,7' werden im Plasma-Ätz-Vorgang simultan geätzt. Das Plasma-Ätzen ist ein bekannter und bewährtes Verfahren und die erwähnten Hinterätzungen und die Tiefe der Ätzungen lässt sich vom Fachmann über die Ätz-Parameter wie beispielsweise Gasdruck, Ätzdauer, etc. genau regeln und kontrollieren. Plasma-Ätzen ist ein umweltschondes Verfahren, bei dem keine verunreinigten Abwässer entstehen, die dann aufbereitet werden müssen und es entstehen auch keine Rückstände, die speziell entsorgt werden müssen.

Dies führt dazu, dass die Kontaktstellen K,K' der Oberflächen O,O' der Folienleiterplatte freigelegt werden, während beispielsweise die Strompfade SP und isolierende Oberflächenbereiche der Isolatorschicht 2 durch die Abdeckschichten A,A' abgedeckt bleiben. Die oben angegebenen Zielvorgaben dieser ersten Ausführungsform einer strukturierten Abdeckung für eine Folienleiterplane sind also erfüllt

**Figur 32** zeigt die mit einer gemäss Figur 31 strukturierten Abdeckung versehene Folienleiterplatte nach dem Entfernen der Maskenfolien 7,7'. Dies kann beispielsweise durch nasschemisches Ätzen geschehen. Bei diesem Verfahrensehritt werden natürlich auch freigelegte Bereiche der Folienleiterplatte wie die Kantaktstellen K,K' chemisch geätzt werden. Man kann die Maskenfolien 7,7' aber sehr dünn (3 bis 5 µm dick) arbeiten, sodass diese weniger 20% der Dicke von Kontaktstellen K,K' ausmachen, sodass bei identischen Ätzraten der Maskenmaterialien und der Kontaktstellenmaterialien, der Materialverlust an den Kontaktstellen K,K' weniger als 20% ausmacht, während die Maskenfolien 7,7' entfernt werden. Dieses Wegätzen von weniger als 20% der Dicken der freigelegter Bereiche der Folienleiterplatte wie Kontakstellen ist tolerierbar. Dies nasschemische Ätzen ist ein bekanntes und bewährtes Verfahren und ist vom Fachmann gut kontrollierbar.

Die Ätzraten auf derart freigelegten Kontaktstellen K,K' und den Maskenfolien 7,7' können aber durchaus verschieden sein. Beispielsweise können die Kontaktatellen K,K' mit Ätzverzögerern oder Ätzschutz wie dünnen Nickelschichten oder chemisch abgeschiedenen Goldschichten versehen sein oder ganz aus solchen Leitern bestehen, sodass solche behandelten Konzaktstellen K,K' beim Nassätzen der Maskenfolien 7,7' zu weniger als 20% oder überhaupt nicht angegriffen werden. Dieses Anbringen von Nickel- oder Goldschichten auf die Kontakstellen K,K' erfolgt vorteilhafterweise vor dem Anbringen der Abdeckung auf die Folienleiterplatte gemäss Figur 29.

Die strukturierten Maskenfolien 7,7' müssen nicht von den strukturierten Abdeckschichten A,A' entfernt werden, sie können sehr wohl auf diesen belassen und als passive elektrische Elemente eingesetzt werden. So sind Anwendungen als elektromagnetische Schirmflächen sinnvoll, beispielsweise als Schirmflächen gegen hochfrequente Strahlungen, welche den Betreib der elektronischen Schaltung der Folienleiterplatte stören können. Bei entsprechender Dicke der Maskenfolien 7,7' können die strukturierten Maskenfolien 7,7' auch als Spannungsversorgungen bzw. als Erdleitungen für die Folienleiterplatte verwendet werden. Die entsprechenden Auslegungen der Dicken der Maskenfolien 7,7', das vielleicht hierzu benötigte Anbringen elektrischer Verbindungen zwischen den Maskenfolien 7,7' und der Folienleiterplatte, all dies kann vom Fachmann bei Kenntnis dieser Erfindung vorgenommen werden.

**Figur 33** zeigt in einer perspektivischen Ansicht einen Teil der Oberfläche O einer beispielhaften Ausführungsform einer Folienleiterplatte mit einer im erfindungsgemässen Verfahren strukturierten Abdeckung. Die Folienleiterplatte ist teilweise von der strukturierten Abdeckschicht A bedeckt. Die Strompfade SP werden so durch eine beispielsweise Polyimid-Schicht der Abdeckschicht A vor schädlichen Umwelteinflüssen geschützt, die Kontaktstelle K hingegen sind in einer rechteckigen Abdecköffnung 4 zugänglich, diese lokale Abdecköffnung 4 kann zur späteren Bestückung mit Bauelementen, zum Drahtbonden, etc. dienen.

Die **Figuren 34** bis **37** zeigen eine weitere Variante des erfindungsgemässen Verfahrens mit mechanischer Strukturierung von Abdeckungen auf einem Teil einer Folienleiterplatte. Dies erfolgt in einem Schnitt entlang der flächigen Ausdehnung der Folienleiterplatte. Der Verfahrensablauf dieser Variante folgt weitgehend der Variante in der Beschreibung gemäss den Figuren 28 bis 32, sodass im folgenden lediglich Abweichungen hiervon erläutert werden.

Der prinzipielle Unterschied zwischen diesen Varianten des erfindungsgemässen Verfahrens ist der, dass in der Variante gemäss den Figuren 34 bis 37 die Maskenfolien 7,7' nicht irreversibel mit den Abdeckschichten A,A' verbunden sind, sondern dass reversibel anbringbare Maskenfolien 7,7' verwendet werden. Diese sind schon mit Kontaktierstrukturen 73,73' versehen und stellen wiederverwertbare Betriebsmittel dar.

**Figur 34** zeigt eine beispielhafte strukturierbar abzudeckende zweilagige Folienleiterplatte, genau wie in Figur 28.

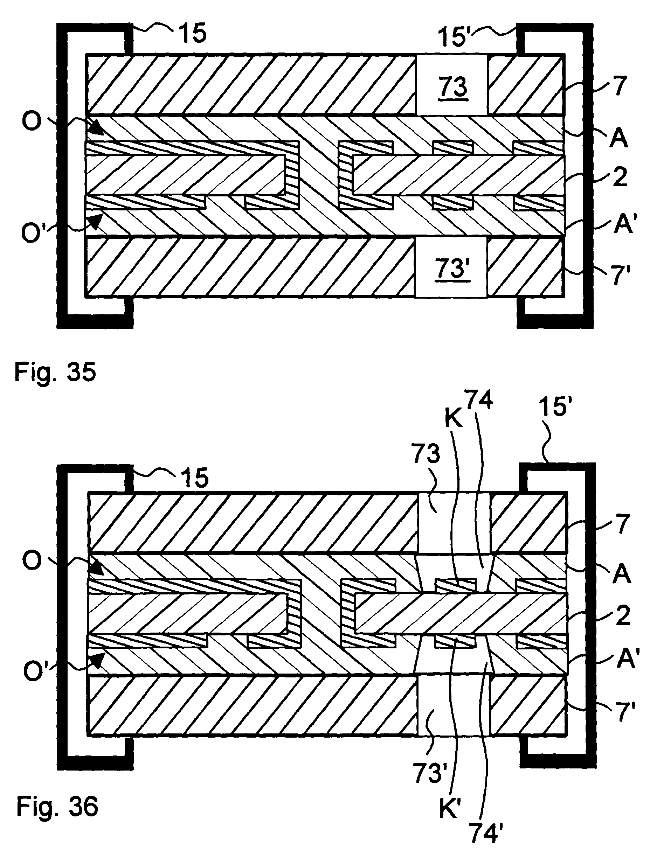

**Figur 35** zeigt wie auf die Oberflächen O,O' der Folienleiterplatte Abdeckungen, bestehend aus Abdeckschichten A,A' und Maskenfolien 7,7' angebracht werden. Die Abdeckschichten A,A' bestehen in dieser Variante aus beispielsweise entlang ihrer flächigen Ausdehnung nur einseitig mit nicht ausgehärtetem Epoxid-Harz beschichteten Polyimid-Folien, welche über diesen Epoxid-Harz mit den Oberflächen O,O' der Folienleiterplatte in einem Verpressvorgang irreversibel verbunden werden. Die Dicken dieser Epoxid-Harz beschichteten Polyimid-Folien sind kleiner 100 µm. Die Maskenfolien 7,7' werden hingegen reversibel mit den Abdeckschichten A,A' verbunden. Die Maskenfolien 7,7' bestehen beispielsweise aus rostfreiem Stahl und weisen Dicken kleiner 100 µm auf. Sie werden mit Haltemitteln wie beispielsweise Klammern 15,15' fixiert und können durch Lösen derselben wieder von den Maskenfolien A,A' entfernt werden. Das Fixieren ist ein dichtes Anpressen. Die Positionierung der Maskenfolien 7,7' geschieht auf bekannte Art und Weise, beispielsweise mittels Registrierbolzen. D.h. auf der Folienleiterplatte und den Maskenfolien 7,7' sind dann besonders geformte Markierungen angebracht, die beispielsweise in Deckung miteinander gebracht werden, wodurch eine kontrollierte Positionierung derselben geschieht. Dadurch, dass die Maskenfolien 7,7' nach dem Plasma-Ätzen von Abdecköffnungen 74,74' wieder entfernt und nicht, wie in der ersten Variante, zerstört oder auf diesen belassen werden, sind sie wiederverwertbare Betriebsmittel.

Die Maskenfolien 7,7' sind durch Formätzen strukturiert und weisen Kontaktierstrukturen 73,73' auf. Die Maskenfolien 7,7' werden also vor ihrem Aufbringen auf die Abdeckschichten A,A' photochemisch in Kontaktierstrukturen 73,73' strukturiert. Beispielsweise werden die Kontaktierstrukturen 73,73' gemäss einer Photomaske in die Maskenfolien 7,7' übertragen, daraufhin werden die Kontaktierstrukturen 73,73' die Maskenfolien 7,7' durchdringend nassgeätzt, derart, dass die Kontaktierstrukturen 73,73' nach Aufbringen der Maskenfolien 7,7' auf die Abdeckschichten A,A' maskenmaterialfreie Bereiche auf den Abdeckschichten A,A' bilden. Es können Kontaktierstrukturen 73,73' von beliebigen Formen und Strukturen, wie runde und eckige Öffnungen, längliche gerade und gebogene Öffnungen, etc. hergestellt werden.

**Figur 36** zeigt die auf der Folienleiterplatte angebrachten Maskenfolien 7,7' gemäss Figur 35 nach mechanischer Strukturierung dieser Abdeckschichten A,A' in Abdecköffnungen 74,74'. Diese Abdecköffnungen 74,74' werden in einem Plasma-Ätz-Vorgang in den von Kupfer ungeschützten Bereichen, gemäss den Kontaktierstrukturen 73,73' der Maskenfolien 7,7' geätzt. Ansonsten schützen die Maskenfolien 7,7' die Abdeckschichten A,A' vor dem Plasma-Angriff, sodass dort keine Ätzung der Abdeckschichten A,A' stattfindet. Die Ränder der Kontaktierstrukturen 73,73' der Maskenfolien 7,7' werden hinterätzt, die Abdecköffnungen 74,74' weisen schräge Wandungen auf. Die Abdecköffnungen 74,74' in den Abdeckschichten A,A' werden bis auf die Oberflächen O,O' der Folienleiterplatte hinunter plasma-geätzt. Dies führt dazu, dass die Kontaktstellen K,K' der Oberflächen O,O' der Folienleiterplatte freigelegt werden, während beispielsweise die Strompfade SP und isolierende Oberflächenbereiche der Isolatorschicht 2 durch die Abdeckschichten A,A' abgedeckt bleiben.

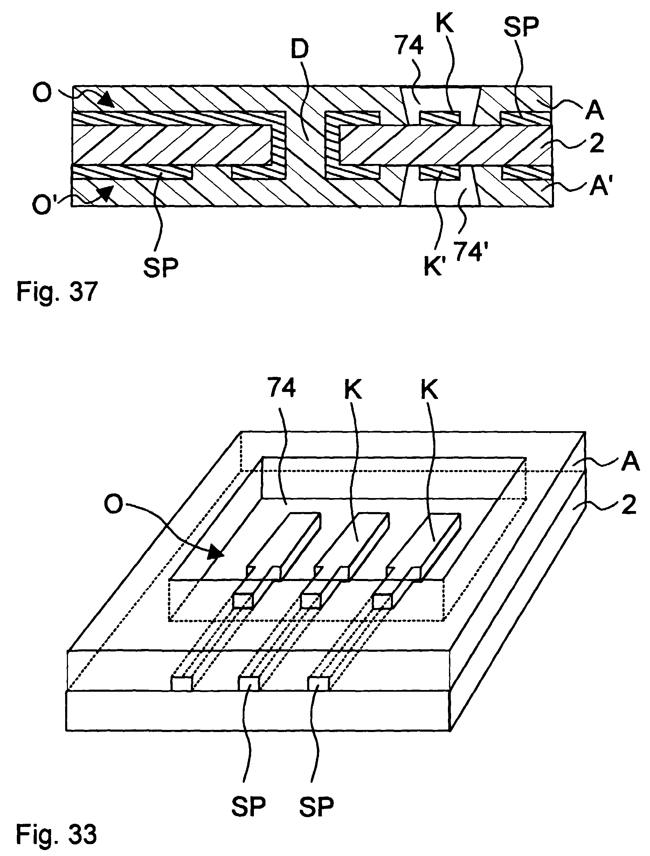

**Figur 37** zeigt die mit einer gemäss Figur 36 strukturierten Abdeckung versehene Folienleiterplatte nach dem Entfernen der Maskenfolien 7,7'. die im erfindungsgemässen Verfahren strukturiert abgedeckte Folienleiterplatte F ist identisch mit derjenigen gemäss Figur 32.

Die im erfindungsgemässen Verfahren hergestellten mehrlagige Leiterplatten und Folienleiterplatten weisen also strukturierte Abdeckungen mit Abdecköffnungen 74,74' auf, die abdeckmaterialfreie Bereiche auf den Leiterplatten und Folienleiterplatten bilden, wobei diese Abdecköffnungen 74,74' frei geformt gearbeitet sind, kreiszylindrische, runde, ovale und auch quadratische, rechteckige, mehreckige Duchmesser aufweisen, wobei diese Abdecköffnungen 74,74' Strukturen mit scharf umrissenen Rändern bilden, deren Auflösung kleiner 100 µm beträgt, die flexibel sind und beim Biegen flexibler Schaltungsträger nicht abplatzen.

## Patentansprüche

1. Verfahren zur Herstellung mehrlagiger Leiterplatten, Folienleiterplatten und zur Herstellung von Halbzeugen für Folienleiterplatten,
mit in Isolatorschichten (2) strukturierten Durchplattierungen (12) und mit in Abdeckschichten (A,A') strukturierten Abdecköffnungen (74,74'),
wobei zur Erniedrigung der Anzahl der benötigten photochemischen Strukturierungen die Durchplattierungen (12) und die Abdecköffnungen (74,74') mechanisch strukturiert werden,
indem in Isolatorschichten (2) vorgearbeitete Durchplattierungsöffnungen (10,10') gemäss Durchgangsöffnungen (8,8') von Maskenfolien (7,7') geätzt werden bzw.
indem in Abdeckschichten (A,A') Abdecköffnungen (74,74') gemäss Kontaktierstrukturen (73,73') von Maskenfolien (7,7') geätzt werden.

2. Verfahren gemäss Anspruch 1, dadurch gekennzeichnet, dass Maskenfolien **(7,7')** wiederentfernbar auf Abdeckschichten **(A,A')** angebracht werden.

3. Verfahren gemäss Anspruch 1, dadurch gekennzeichnet, dass Maskenfolien (**7,7'**) nicht wiederentfernbar auf Abdeckschichten (**A,A'**) angebracht werden.

4. Verfahren gemäss Anspruch 1, dadurch gekennzeichnet, dass Abdecköffnungen (**74,74'**) als abdeckmaterialfreie Bereiche auf Leiterplatten, Folienleiterplatten und auf Halbzeugen für Folienleiterplatten geätzt werden, dass dies Kontaktierstellen (**K,K'**) sind und dass andere Bereiche der Leiterplatten, Folienleiterplatten und Halbzeuge für Folienleiterplatten durch die Maskenfolien (**7,7'**) bedeckt bleiben,.

5. Verfahren gemäss Anspruch 4, dadurch gekennzeichnet, dass die Abdecköffnungen (**74,74'**) frei geformt geätzt werden und dass sie Durchmesser mit kreiszylindrischer, runder, ovaler und auch quadratischer, rechteckiger, mehreckiger Form aufweisen.

6. Verfahren gemäss Anspruch 1, dadurch gekennzeichnet, dass als Abdeckschichten (**A,A'**) Epoxid-Harz verwendet wird.

7. Verfahren gemäss einem der Ansprüche 1 oder 6, dadurch gekennzeichnet, dass die Maskenfolien (**7,7'**) vor ihrem Aufbringen auf die Abdeckschichten (**A,A'**) photochemisch in Kontaktierstrukturen (**73,73'**) strukturiert werden, dass die Kontaktierstrukturen (**73,73'**) gemäss einer Photomaske in die Maskenfolien (**7,7'**) übertragen werden, dass die Kontaktierstrukturen (**73,73'**) die Maskenfolien (**7,7'**) durchdringend nassgeätzt werden und dass die Kontaktierstrukturen (**73,73'**) somit nach Aufbringen der Maskenfolien (**7,7'**) auf die Abdeckschichten (**A,A'**) maskenmaterialfreie Bereiche auf den Abdeckschichten (**A,A'**) bilden.

8. Verfahren gemäss Anspruch 1, dadurch gekennzeichnet, dass die Maskenfolien (**7,7'**) nach ihrem Aufbringen auf die Abdeckschichten (**A,A'**) photochemisch in Kontaktierstrukturen (**73,73'**) strukturiert werden, dass die Kontaktierstrukturen (**73,73'**) gemäss einer Photomaske in die Maskenfolien (**7,7'**) übertragen werden, dass die Kontaktierstrukturen (**73,73'**) bis auf die Abdeckschichten (**A,A'**) herab nassgeätzt werden und dass die Kontaktierstrukturen (**73,73'**) somit maskenmaterialfreie Bereiche auf den Abdeckschichten (**A,A'**) bilden.

9. Verfahren gemäss einem der Ansprüche 7 oder 8, dadurch gekennzeichnet, dass die Kontaktierstrukturen (**73,73'**) der Maskenfolien (**7,7'**) frei geformt gearbeitet werden und dass sie kreiszylindrische, runde, ovale und auch quadratische, rechteckige, mehreckige Duchmesser aufweisen können.

10. Verfahren gemäss Anspruch 1, dadurch gekennzeichnet, dass als Maskenfolien (**7,7'**) dünne Leiterfolien aus Kupfer, rostfreiem Stahl, Messing, Bronze, Aluminium-Magnesium-Legierungen, Invar, Molybdän verwendet werden und dass die Dicken dieser Maskenfolien (**7,7'**) kleiner 100 µm beträgt.

11. Verfahren gemäss Anspruch 2, dadurch gekennzeichnet, dass Maskenfolien (**7,7'**) über Haltemitteln wie Klammern auf Abdeckschichten (**A,A'**) fixiert und durch Lösen derselben wieder von den Abdeckschichten (**A,A'**) entfernt werden, dass die Maskenfolien (**7,7'**) durch dieses Fixieren dicht auf die Abdeckschichten (**A,A'**) angepresst werden, dass die Maskenfolien (**7,7'**) mittels Registrierbolzen kontrolliert positioniert werden, wobei die Leiterplatten, Folienleiterplatten und die Halbzeuge für Folienleiterplatten und die Maskenfolien (**7,7'**) über besonders geformte Markierungen in Deckung miteinander gebracht werden.

12. Verfahren gemäss Anspruch 11, dadurch gekennzeichnet, dass die Maskenfolien (**7,7'**) als wiederverwendbare Betriebsmittel für Strukturierungen verwendet werden.

13. Verfahren gemäss Anspruch 3, dadurch gekennzeichnet, dass nach der Strukturierung der Abdeckung die Maskenfolien (**7,7'**) weggeätzt werden.

14. Verfahren gemäss Anspruch 13, dadurch gekennzeichnet, dass Maskenfolien (**7,7'**) mit Dicken von weniger als 20% der Dicken von in der Abdeckung freigelegten Kontaktstellen (**K,K'**) angebracht werden, dass Maskenmaterialien und Kontaktstellenmaterialien mit gleichen Ätzraten verwendet werden und dass beim Wegätzen der Maskenfolien (**7,7'**) weniger als 20% der Dicken der Kontaktstellen (**K,K'**) weggeätzt werden.

15. Verfahren gemäss Anspruch 13, dadurch gekennzeichnet, dass Maskenmaterialien und Kontaktstellenmaterialien mit unterschiedlichen Ätzraten verwendet werden und dass beim Wegätzen der Maskenfolien (**7,7'**) weniger als 20% der Dicken der Kontaktstellen (**K,K'**) weggeätzt werden.

16. Verfahren gemäss Anspruch 1, dadurch gekennzeichnet, dass nach der Strukturierung der Abdeckung die Maskenfolien (**7,7'**) auf der Abdeckung gelassen werden.

17. Verfahren gemäss Anspruch 16, dadurch gekennzeichnet, dass die Maskenfolien (**7,7'**) als passive elektrische Elemente eingesetzt werden, dass sie als elektromagnetische Schirmflächen verwendbar sind, dass sie als Schirmflächen gegen den Betrieb der elektronischen Schaltung der Leiterplatten, Folienleiterplatten und Halbzeuge für Folienleiterplatten störende hochfrequente Strahlungen verwendbar sind, dass sie als Spannungsversorgungen bzw. als Erdleitungen für die Leiterplatten, Folienleiterplatten und Halbzeuge für Folienleiterplatten verwendbar sind.

18. Maskenfolien (**7,7'**) zur Durchführung des Verfahrens gemäss einem der Ansprüche 1 bis 17 sowie 19 bis 33, dadurch gekennzeichnet, dass die Maskenfolien (**7,7'**) dünne Leiterfolien aus Kupfer, rostfreiem Stahl, Messing, Bronze, Aluminium-Magnesium-Legierungen, Invar, Molybdän sind und dass die Dicken dieser Maskenfolien (**7,7'**) kleiner 100 µm beträgt.

19. Verfahren gemäss Anspruch 1, dadurch gekennzeichnet, dass in den Durchplattierungsöffnungen (**10,10'**) elektrisch leitfähige Abscheidesubstanzen zur Bildung von Kontaktschichten (**11**) in den Durchplattierungsöffnungen (**10**) abgeschieden verden und dass die Maskenfolien (**7,7'**) anschliessend entfernt werden können.

20. Verfahren gemäss Anspruch 19, dadurch gekennzeichnet, dass die Strukturierung an einem Ausgangsmaterial (**V**) vorgenommen wird und dass die Maskenfolien (**7,7'**) mittels Klammern (**15,15'**) auf dem Ausgangsmaterial (**V**) gepresst positioniert werden.

21. Verfahren gemäss Anspruch 20, dadurch gekennzeichnet, dass die Maskenfolien (**7,7'**) konkav geformt sind und beim Anpressen auf das Ausgangsmaterial (**V**) unter einer Biegespannung positioniert werden.

22. Verfahren gemäss Anspruch 20, dadurch gekennzeichnet, dass die Strukturierung von Isolatorschichten (**2**) nach einer photochemischen Strukturierung von Leiterschichten (**1,1'**) zu Strompfaden (**SP**) und Lötaugen (**L**) erfolgt.

23. Verfahren gemäss Anspruch 22, dadurch gekennzeichnet, dass zur photochemischen Strukturierung von Leiterschichten (**1,1'**) Photoresistschichten (**3,3'**) auf Leiterschichten (**1,1'**) appliziert werden, dass diese Photoresistschichten (**3,3'**) zu Strompfadstrukturen (**5**) belichtet und entwickelt werden, dass die Leiterschichten (**1,1'**) gemäss den Strompfadstrukturen (**5**) zu Strompfaden (**SP**) und Lötaugen (**L**) geätzt werden.

24. Verfahren gemäss Anspruch 20, dadurch gekennzeichnet, dass die Strukturierung von Isolatorschichten (**2**) nach photochemischer Strukturierung von Leiterschichten (**1,1'**) zu Durchplattierungsbereichen (**4***) erfolgt.

25. Verfahren gemäss Anspruch 24, dadurch gekennzeichnet, dass zur photochemischen Strukturierung von Leiterschichten (**1,1'**) zu Durchplattierungsbereichen (**4***) Photoresistschichten (**3,3'**) auf diese Leiterschichten (**1,1'**) appliziert werden, dass diese Photoresistschichten (**3,3'**) zu Durchplattierungsstrukturen (**4,4'**) belichtet und entwickelt werden, dass die Leiterschichten (**1,1'**) gemäss den Durchplattierungsstrukturen (**4,4'**) zu Durchplattierungsbereichen (**4***) geätzt werden.

26. Verfahren gemäss einem der Ansprüche 23 oder 25, dadurch gekennzeichnet, dass die Durchplattierungsbereiche (**4***) von Lötaugen (**L**) umgeben geätzt werden.

27. Verfahren gemäss Anspruch 26, dadurch gekennzeichnet, dass der Aussendurchmesser von Durchgangsöffnungen (**8,8'**) der Maskenfolien (**7,7'**) kleiner als der Aussendurchmesser der Lötaugen (**L**) und grösser als der Aussendurchmesser der Durchplattierungsbereiche (**4***) der Leiterschichten (**1,1'**) gearbeitet wird, und dass man optimal dimensionierte Durchgangsöffmungen (**8,8'**) mit einem günstigsten Durchmesser (**D**_{**g**}) verwendet, welcher sich aus dem Aussendurchmesser der Lötaugen (**L**) minus dem Aussendurchmesser der Durchgangsöffnungen (**8,8'**) dividiert durch zwei berechnet,

28. Verfahren gemäss einem der Ansprüche 22 oder 24, dadurch gekennzeichnet, dass die photochemische Strukturierung der Strompfade (**SP**), der Lötaugen (**L**) und der Durchplattierungsbereiche (**4***) von Leiterschichten (**1,1'**) in einem Verfahrensschritt erfolgt.

29. Verfahren gemäss Anspruch 20, dadurch gekennzeichnet, dass lokal dünne Schwachstellen (**17,17'**) mit Dicken kleiner 10 µm angebracht werden, welche ein beschädigungsfreies Lösen der Maskenfolien (**7,7'**) vom Ausgangsmaterial (**V**) nach erfolgter Strukturierung ermöglichen.

30. Verfahren gemäss einem der Ansprüche 24 oder 29, dadurch gekennzeichnet, dass die Bildung von Schwachstellen (**17,17'**) durch hinterätzte Bereiche (**14,14'**) von Schichten Photoresisit (**3,3'**) induziert werden, dass diese in einem weiteren Schritt nach Positionierung der Maskenfolien (**7,7'**) auf dem Ausgangsmaterial (**V**) enge Hohlräume im Bereich der Verbindung zwischen dem Ausgangsmaterial (**V**) und den Maskenfolien (**7,7'**) bilden und dass in diesen Hohlräumen lokal geringere Mengen Abscheidesubstanz abgeschieden werden, wodurch lokal Schwachstellen (**17,17'**) gebildet werden.

31. Verfahren gemäss Anspruch 29, dadurch gekennzeichnet, dass die Bildung von Schwachstellen (**17,17'**) durch Ausformungen (**20,20'**) der Durchgangsöffnungen (**8,8'**) der Maskenfolien (**7,7'**) induziert werden, dass diese in einem weiteren Schritt nach Positionierung der Maskenfolien (**7,7'**) auf dem Ausgangsmaterial (**V**) enge Hohlräume im Bereich der Verbindung zwischen Ausgangsmaterial (**V**) und den Maskenfolien (**7,7'**) bilden und dass in diesen Hohlräumen lokal geringere Mengen Abscheidesubstanz abgeschieden werden, wodurch lokale Schwachstellen (**17,17'**) gebildet werden.

32. Verfahren gemäss Anspruch 29, dadurch gekennzeichnet, dass die Bildung von Schwachstellen (**17,17'**) durch chemische Potentialdifferenzen zwischen den benutzten Materialien induziert werden, dass auf den Maskenfolien (**7,7'**) geringere Mengen Abscheidesubstanz als auf dem Ausgangsmaterial (**V**) abgeschieden werden wodurch lokale Schwachstellen (**17,17'**) gebildet werden.

33. Verfahren gemäss einem der Ansprüche 19 bis 32, dadurch gekennzeichnet, dass polierte Maskenfolien (**7,7'**) verwendet werden, von denen sich aufplattierte Kontaktschichten (**11**) leicht ablösen lassen.

## Claims

1. Method for the manufacture of multilayer printed circuit boards, foil circuit boards and for the manufacture and metal clad laminates for foil circuit boards with interfacial connections (**12**) structured in insulator layers (**2**) and with resist openings (**74, 74'**) structured in resist coatings (**A, A'**),
whereby for reducing the number of required photochemical structuring the interfacial connections **12** and the resist openings (**74, 74'**) are structured mechanically,
in that interfacial connection openings (**10, 10'**) preworked in insular layers (**2**) are etched in accordance with interfacial connection openings (**8, 8'**) of mask foils (**7, 7'**) or
in that in resist coatings (**A, A'**) resist openings (**74, 74'**) of (**7, 7'**) are etched according to contacting structures (**73, 73'**) of mask foils (**7, 7'**) respectively.

2. Method according to claim 1, characterized in that the mask foils (**7, 7'**) are reversibly applied to the resist coatings (**A, A'**).

3. Method according to claim 1, characterized in that the mask foils (**7, 7'**) are irreversibly applied to resist coatings (**A, A'**).

4. Method according to claim 1, characterized in that the resist openings (**74, 74'**) are etched as resist material-free areas on circuit boards, foil circuit boards and on metal-clad laminates for foil circuit bonds, that these are contacting points (**K, K'**) and that other areas of the circuit boards, foil circuit boards and metal-clad laminates for foil circuit boards remain covered by mask foils (**7, 7'**).

5. Method according to claim 4, characterized in that the resist openings (**74, 74'**) are etched in a freely shaped manner and they have circular cylindrical, round, oval, square, rectangular and polygonal diameters.

6. Method according to claim 1, characterized in that epoxy resin is used as resist coatings (**A, A'**).

7. Method according to one of claims 1 to 6, characterized in that prior to the application of the mask foils (**7, 7'**) to the resist coatings (**A, A'**) they are photochemically structured in contacting structures (**73, 73'**), that the contacting structures (**73, 73'**) are transferred in accordance with a photomask into the mask foils (**7, 7'**), that the contacting structures (**73, 73'**) are wet etched through the mask foils (**7, 7'**) and that consequently the contacting structures (**73, 73'**) following the application of the mask foils (**7, 7'**) to the resist coatings (**A, A'**) form mask material-free areas on the resist coatings (**A, A'**).

8. Method according to claim 1, characterized in that following the application of the mask foils (**7, 7'**) to the resist coatings (**A, A'**) they are photochemically structured in contacting structures (**73, 73'**), that the contacting structures (**73, 73'**) are transferred in accordance with a photomask into the mask foils (**7, 7'**), that the contacting structures (**73, 73'**) are wet etched clown to the resist coatings (**A, A'**) and that consequently the contacting structures (**73, 73'**) form mask material-free areas on the resist coatings (**A, A'**).

9. Method according to one of claims 7 or 8, characterized in that the contacting structures (**73, 73'**) of the mask foils (**7, 7'**) are worked in a freely formed manner and can have circular cylindrical, oval, square, rectangular and polygonal diameters.

10. Method according to claim 1, characterized in that the mask foils (**7, 7'**) are constituted by thin conductor foils of copper, stainless steel, brass, bronze, aluminum-magnesium alloys, invar and molybdenum and that the thicknesses of said mask foils (**7, 7'**) are below 100 µm.

11. Method according to claim 2, characterized in that the mask foils (**7, 7'**) are fixed to the resist coatings (**A, A'**) by holding means such as clips and are removed again from the resist coatings (**A, A'**) by detaching the clips, that the mask foils (**7, 7'**) are pressed by this fixing action tightly onto the resist coatings (**A, A'**), that the mask foils (**7, 7'**) are positioned in controlled manner by means of registering bolts, the circuit boards, foil circuit boards and metal clad laminates for foil circuit boards and the mask foils (**7, 7'**) being made to coincide by means of specially shaped markings.

12. Method according to claim 11, characterized in that the mask foils (**7, 7'**) are used as reusable resources for structuring.

13. Method according to claim 11, characterized in that following the structuring of the covering of the mask foils (**7, 7'**) are etched away.

14. Method according to claim 13, characterized in that mask foils (**7, 7'**) with thicknesses of less than 20% of the thicknesses of the contact points (**K, K'**) exposed to the covering are fitted, the mask materials and contact point materials with the same etching rates are used and that on etching away the mask foils (**7, 7'**) less than 20% of the thicknesses of the contact points (**K, K'**) are etched away.

15. Method according to claim 13, characterized in that mask materials and contact materials with different etching rates are used and that on etching away the mask foils (**7, 7'**) less than 20% of the thicknesses of the contact points (**K, K'**) are etched away.

16. Method according to claim 1 characterized in that following the structuring of the covering the mask foils (**7, 7'**) are left on the covering.

17. Method according to claim 16, characterized in that the mask foils (**7, 7'**) are used as passive electrical elements, that they are usable as shielding surfaces, that they are usable as shielding surfaces against high frequency radiation interfering with the operation of the electronic circuit of the circuit boards, foil circuit boards and metal-clad laminates for foil circuit boards and that they are usable as voltage supplies or as earth leads for circuit boards, foil circuit boards and metal-clad laminates for the foil circuit boards.

18. Mask foils (**7, 7'**) for carrying out the method according to one of claims 1 to 17 as well as 19 to 33, characterized in that the mask foils (**7, 7'**) are thin conductor foils of copper, stainless steel, brass, bronze, aluminum-magnesium alloys, invar and molybdenum and that the thicknesses of said mask foils (**7, 7'**) are below 100 µm.

19. Method according to claim 1, characterized in that in the interfacial connection openings (**10, 10'**) electrically conductive deposition substances for the formation of contact layers (**11**) in the interfacial openings (**10**) are deposited and that the mask foils (**7, 7'**) can be subsequently removed.

20. Method according to claim 19, characterized in that the structuring takes place on a base material (**V**) and that the mask foils (**7, 7'**) are positioned in pressed manner on the base material (**V**) by means of clips (**15, 15'**).

21. Method according to claim 20, characterized in that the mask foils (**7, 7'**) have a concave shape and are positioned under a bending stress when pressing onto the base material (**V**).

22. Method according to claim 20, characterized in that the structuring of insulator layers (**2**) takes place following a photochemical structuring of conductor layers (**1, 1'**) to current paths (**SP**) and pads (**L**).

23. Method according to claim 22, characterized in that for the photochemical structuring of conductor layers (**1, 1'**) photo resist coatings (**3, 3'**) are exposed and developed to current path structures (**5**) and that said photo resist coatings (**3, 3'**) are exposed and developed to current path structures (**5**) and that said layers (**1, 1'**) are etched in accordance with current path structures (**5**) to current path structures (**SP**) and pads (**L**).

24. Method according to claim 20, characterized in that the mechanical structuring of the insulator layers (**2**) takes place after the photochemical structuring of conductor layers (**1, 1'**) to interfacial connection openings (**4***).

25. Method according to claim 24, characterized in that for the photochemical structuring of conductor layers (**1, 1'**) to interfacial connection openings (**4***) photoresist coatings (**3, 3'**) are applied to said conductor layers (**1, 1'**), that said photoresist coatings (**3, 3'**) are exposed and developed to interfacial connection structures (**4, 4'**) and that the conductor layers (**1, 1'**) are etched according to the interfacial connection structures (**4, 4'**) to interfacial connection openings (**4***).

26. Method according to claims 23 or 25, characterized in that the interfacial connection openings (**4***) are etched surrounded by pads (**L**).

27. Method according to claim 26, characterized in that the external diameter of the trough openings (**8, 8'**) of the mask foils (**7, 7'**) is smaller than the external diameter of the pads (**L**) and larger than the external diameter of the interfacial connection openings (**4***) of the conductor layers (**1, 1'**) and that use is made of optimum dimensioned through openings (**8 ,8'**) with the most favorable diameter (**D**_{**g**}) which is calculated from the external diameter of the pads (**L**) minus the external diameter if the through openings (**8, 8'**) divided by two.

28. Method according to claim 22 or 24, characterized in that the photochemical structuring of the current paths (**SP**), pads (**L**) and interfacial connection openings (**4***) of conductor layers (**1, 1'**) takes place in one method step.

29. Method according to claim 20, characterized in that locally thin weak points (**17, 17'**) with thicknesses below 10 µm are applied, which allow a damage-free detachment of the mask foils (**7, 7'**) from the base material (**V**) after mechanical structuring has taken place.

30. Method according to claims 24 or 29, characterized in that the formation of weak points (**17, 17'**) is brought about by back-etched areas (**14, 14'**) of photoresist coatings (**3, 3'**), that the latter form in a further step following the positioning of the mask foils (**7, 7'**) on the base material (**V**) narrow cavities in the vicinity of the connection between the base material (**V**) and the mask foils (**7, 7'**) and in said cavities are locally deposited small amounts of deposition substance, such that local weak points (**17, 17'**) are formed.

31. Method according to claim 29, characterized in that the formation of the weak points (**17, 17'**) is induced by shapes (**20, 20'**) of the through openings (**8, 8'**) of the mask foils (**7, 7'**), in a further step and following the positioning of the mask foils (**7, 7'**) on the base material (**V**) they form narrow cavities in the vicinity of the connection between the intermediate product (**V**) and the mask foils (**7, 7'**) and in that said cavities are locally deposited small amounts of deposition substance, so that local weak points (**17, 17'**) are formed.

32. Method according to claim 29, characterized in that the formation of weak points (**17, 17'**) is induced by chemical potential differences between the materials used and that on the mask foils (**7, 7'**) smaller amounts of deposition substance are deposited than on the base material (**V**) such that local weak points (**17, 17'**) are formed.

33. Method according to one of claims 19 to 32, characterized in that polished mask foils (**7, 7'**) are used from which it is easily possible to detach plated contact layers (**11**).

## Revendications

1. Procédé pour la fabrication de circuits imprimés multicouches, circuits imprimés sur pellicule et pour la fabrication de semi-produits pour circuits imprimés sur pellicule,
comprenant des métallisations de trous (12) structurées dans des couches isolantes (2) et des fenêtres de revêtement (74, 74') structurées dans des couches de revêtement (A, A'),
dans lequel, pour réduire le nombre des structurations photochimiques nécessaires, les métallisations de trous (12) et les fenêtres de revêtement (74, 74') sont structurées mécaniquement,
dans lequel des trous à métalliser (10, 10') préalablement pratiques dans des couches isolantes (2) sont soumises a une attaque chimique en reproduisant la forme d'ouvertures traversantes (8, 8') de pellicules de masques (7, 7'), ou
dans lequel des fenêtres du revêtement (74, 74') sont soumises à une attaque chimique dans des couches de revêtement (A, A') en reproduisant la forme de structures de connexion (73, 73') de pellicules de masques (7, 7').

2. Procédé selon la revendication 1, caractérisé en ce que des pellicules de masques (7, 7') sont appliquées sur des couches de revêtement (A, A') d'une manière telle qu'elles puissent être enlevées.

3. Procédé selon la revendication 1, caractérisé en ce que des pellicules de masques (7, 7') sont déposées sur des couches de revêtement (A, A') d'une manière telle qu'elle ne puissent plus en être enlevées.

4. Procédé selon la revendication 1, caractérisé en ce que des fenêtres de revêtement (74, 74') sont formées par une attaque chimique sous la forme de régions exemptes de matière de revêtement sur des circuits imprimés, circuits imprimés sur pellicule et sur des semi-produits pour des circuits imprimés sur pellicule, en ce que ce sont là des zones de connexion (K, K') et en ce que d'autres régions des circuits imprimés, circuits imprimés sur pellicules et semi-produits pour circuits imprimés sur pellicule restent couvertes par les pellicules de masques (7, 7').

5. Procédé selon la revendication 4, caractérisé en ce que les fenêtres de revêtement (74, 74') sont formées par attaque chimique selon une forme libre et en ce qu'elles présentent des diamètres d'une forme cylindrique à base circulaire, ronde, ovale ou encore carrée, rectangulaire, polygonale.

6. Procédé selon la revendication 1, caractérisé en ce que, comme couches de revêtement (A, A'), on utilise une résine époxyde.

7. Procédé selon une des revendications 1 ou 6, caractérisé en ce que les pellicules de masques (7, 7') sont structurées en structures de connexion (73, 73') par voie photochimique avant leur application sur les couches de revêtement (A, A'), en ce que les structures de connexion (73, 73') sont reportées dans les pellicules de masques (7, 7') en reproduisant la forme d'un masque photographique, en ce que les structures de connexion (73, 73') sont formées par attaque chimique par voie humide à travers les pellicules de masques (7, 7') et en ce que les structures de connexion (73, 73') forment ainsi sur les couches de revêtement (A, A'), des régions exemptes de matière de masque après l'application des pellicules de masques (7, 7') sur les couches de revêtement (A, A').

8. Procédé selon la revendication 1, caractérisé en ce que les pellicules de masques (7, 7') sont structurées en structures de connexion (73, 73') par voie photochimique après leur application sur les couches de revêtement (A, A'), en ce que les structures de connexion (73, 73') sont reportées dans les pellicules de masques (7, 7') en reproduisant la forme d'un masque photographique, en ce que les structures de connexion (73, 73') sont soumises à une attaque chimique par voie humide qui creuse jusqu'aux couches de revêtement (A, A') et en ce que les structures de connexion (73, 73') forment ainsi des régions dépourvues de matière de masque sur les couches de revêtement (A, A').

9. Procédé selon une des revendications 7 ou 8, caractérisé en ce que les structures de connexion (73, 73') des pellicules de masques (7, 7') sont travaillées selon une forme libre et en ce qu'elles peuvent présenter des diamètres d'une forme cylindrique à base circulaire, ronde, ovale ou encore carrée, rectangulaire, polygonale.

10. Procédé selon la revendication 1, caractérisé en ce qu'on utilise comme pellicules de masques (7, 7') des pellicules conductrices minces faites de cuivre, d'acier inoxydable, de laiton, de bronze, d'alliages alluminium-magnésium, d'invar, de molybdène, et en ce que les épaisseurs de ces pellicules de masques (7, 7') sont inférieures à 100 µm.

11. Procédé selon la revendication 2, caractérisé en ce que les pellicules de masques (7, 7') sont fixées sur des couches de revêtement (A, A') à l'aide de moyens de retenue tels que des crampons et qu'elles sont de nouveau détachées des couches de revêtement (A, A') par leur desserrage, en ce que les pellicules de masques (7, 7') sont pressées étroitement sur les couches de revêtement (A, A') par cette fixation, en ce que les pellicules de masques (7, 7') sont positionnées de façon contrôlée au moyen de tenons de repérage, les circuits imprimés, circuits imprimés sur pellicule et les semi-produits pour circuits imprimés sur pellicule et les pellicules de masques (7, 7') étant mis en coïncidence entre eux au moyen de marquages spécialement formés.

12. Procédé selon la revendication 11, caractérisé en ce que les pellicules de masques (7, 7') sont utilisées en tant qu'outillages réutilisables pour les structurations.

13. Procédé selon la revendication 3, caractérisé en ce qu'après la structuration du revêtement, les pellicules de masques (7, 7') sont enlevées par attaque chimique.

14. Procédé selon la revendication 13, caractérisé en ce qu'on applique des pellicules de masques (7, 7') possédant des épaisseurs de moins de 20% des épaisseurs de zones de contact (K, K') dégagées dans le revêtement, en ce qu'on utilise des matières de masques et des matières de zones de contact possédant les mêmes vitesses d'attaque, et en ce que, lors de l'enlèvement des pellicules de masques (7, 7') par attaque chimique, on enlève moins de 20% de l'épaisseur des zones de contact (K, K').

15. Procédé selon la revendication 13, caractérisé en ce qu'on utilise des matières de masques et des matières de zones de contact possédant différentes vitesses d'attaque chimique et en ce que, lors de l'enlèvement des pellicules de masques (7, 7') par attaque chimique, on enlève moins de 20% de l'épaisseur des zones de contact (K, K').

16. Procédé selon la revendication 1, caractérisé en ce qu'après la structuration du revêtement, les pellicules de masques (7, 7') sont laissées sur le revêtement.

17. Procédé selon la revendication 16, caractérisé en ce que les pellicules de masques (7, 7') sont utilisées comme éléments électriques passifs, en ce qu'elles peuvent être utilisées comme surfaces de blindage électromagnétique, en ce qu'elles peuvent être utilisées comme surface de blindage pour protéger contre les rayonnements à haute fréquence qui perturberaient le fonctionnement du montage électronique des circuits imprimés, circuits imprimés sur pellicule et semi-produits pour circuits imprimés sur pellicule, en ce qu'elles peuvent être utilisées comme alimentations en tension ou comme conducteurs de masse pour les circuits imprimés, circuits imprimés sur pellicule et semi-produits pour circuits imprimés sur pellicule.

18. Pellicules de masques (7, 7') pour la mise en oeuvre du procédé selon une des revendications 1 à 17 ainsi que 19 à 33, caractérisées en ce que les pellicules de masques (7, 7') sont des pellicules conductrices minces faites de cuivre, d'acier inoxydable, de laiton, de bronze, d'alliages alluminium-magnésium, d'invar, de molybdène, et en ce que les épaisseurs de ces pellicules de masques (7, 7') sont inférieures à 100 µm.

19. Procédé selon la revendication 1, caractérisé en ce que, dans les trous de métallisation (10, 10'), on dépose des substances de dépôt conductrices de l'électricité pour former des couches de contact (11) dans les ouvertures de métallisation des trous (10) et en ce que les pellicules de masques (7, 7') peuvent être enlevées ensuite.

20. Procédé selon la revendication 19, caractérisé en ce que la structuration est exécutée sur une matière de départ (V) et en ce que les pellicules de masques (7, 7') sont positionnées en étant pressées sur la matière de départ (V) au moyen de crampons (15, 15').

21. Procédé selon la revendication 20, caractérisé en ce que les pellicules de masques (7, 7') sont formées dans une forme concave et que, lors du pressage sur la matière de départ (V), elles sont positionnées sous une contrainte de flexion.

22. Procédé selon la revendication 20, caractérisé en ce que la structuration de couches isolantes (2) s'effectue après une structuration photochimique de couches conductrices (1, 1') qui forme des pistes de passage de courant (SP) et des pastilles (L).

23. Procédé selon la revendication 22, caractérisé en ce que, pour la structuration photochimique de couches conductrices (1, 1'), des couches de photorésist (3, 3') sont appliquées sur des couches conductrices (1, 1'), en ce que ces couches de photorésist (3, 3') sont impressionnées et développées pour former des structures de pistes de passage du courant (5), en ce que les couches conductrices (1, 1') sont attaquées chimiquement en reproduisant la forme des structures de pistes de passage du courant (5) pour former des pistes de passage du courant (SP) et des pastilles (L).

24. Procédé selon la revendication 20, caractérisé en ce que la structuration de couches isolantes (2) s'effectue après la structuration photochimique de couches conductrices (1, 1') qui forme des régions de métallisation de trous (4').

25. Procédé selon la revendication 24, caractérisé en ce que, pour la structuration photochimique de couches conductrices (1, 1') pour former des régions de métallisation de trous (4'), des couches de photorésist (3, 3') sont appliquées sur ces couches conductrices (1, 1'), en ce que ces couches de photorésist (3, 3') sont impressionnées et développées pour former des structures de métallisation de trous (4, 4'), en ce que les couches conductrices (1, 1') sont attaquées chimiquement en reproduisant la forme de structures de métallisation de trous (4, 4') pour former des régions de métallisation de trous (4').

26. Procédé selon une des revendications 23 ou 25, caractérisé en ce que les régions de métallisation des trous (4') sont attaquées chimiquement de façon à être entourées de pastilles (L).

27. Procédé selon la revendication 26, caractérisé en ce que le diamètre extérieur des ouvertures traversantes (8, 8') des pellicules de masques (7, 7') est réalisé plus petit que le diamètre extérieur des pastilles (L) et plus grand que le diamètre extérieur des régions de métallisation de trous (4') des couches conductrices (1, 1'), et en ce qu'on utilise des ouvertures traversantes (8, 8') d'une dimension optimale, qui possèdent le diamètre le plus favorable (D₂), qui est calculé à partir du diamètre extérieur des pastilles (L) diminué du diamètre extérieur des ouvertures traversantes (8, 8') divisé par deux.

28. Procédé selon une des revendications 22 ou 24, caractérisé en ce que la structuration photochimique des pistes de passage du courant (SP), des pastilles (L) et des régions de métallisation de trous (4') des couches conductrices (1, 1') s'effectue en une étape du procédé.

29. Procédé selon la revendication 20, caractérisé en ce qu'on forme localement des zones faibles (17, 17') minces possédant des épaisseurs inférieures à 10 µm, qui permettent de détacher les pellicules de masques (7, 7') de la matière de départ (V) sans les détériorer après exécution de la structuration.

30. Procédé selon une des revendications 24 ou 29, caractérisé en ce que la formation des zones faibles (17, 17') est induite par des régions (14, 14') de couches de photorésist (3, 3') qui sont affouillées par attaque chimique par l'arrière, en ce que ces dernières, dans une autre étape après le positionnement des pellicules de masques (7, 7') sur la matière de départ (V), forment d'étroites cavités dans la région de la liaison entre la matière de départ (V) et les pellicules de masques (7, 7') et en ce que, dans ces cavités, on dépose des quantités localement réduites d'une substance de dépôt, de sorte qu'il se forme localement des zones faibles (17, 17').

31. Procédé selon la revendication 29, caractérisé en ce que la formation de zones faibles (17, 17') est induite par des déformations (20, 20') des ouvertures traversantes (8, 8') des pellicules de masques (7, 7'), en ce que, dans une autre étape après le positionnement des pellicules de masques (7, 7') sur la matière de départ (V), ces déformations forment d'étroites cavités dans la région de la liaison entre la matière de départ (V) et les pellicules de masques (7, 7') et en ce que, dans ces cavités, sont déposées des quantités localement réduites d'une substance de dépôt, ce qui donne naissance à des zones faibles locales (17, 17').

32. Procédé selon la revendication 29, caractérisé en ce que la formation de zones faibles (17, 17') est induite par des différences de potentiel chimique entre les matières utilisées, en ce qu'on dépose de plus petites quantités d'une substance de dépôt sur les pellicules de masques (7, 7') que sur la matière de départ (V), ce qui donne naissance à des zones faibles locales (17, 17').

33. Procédé selon une des revendications 19 à 32, caractérisé en ce qu'on utilise des pellicules de masques polies (7, 7'), d'où les couches de contact (11) plaquées sur elles se laissent détacher facilement.
